# EUROPÄISCHE PATENTSCHRIFT

(11) **EP 2 136 981 B1**
(45) Veröffentlichungstag und Bekanntmachung des Hinweises auf die Patenterteilung: **05.06.2013**
(21) Anmeldenummer: 08757937.1
(22) Anmeldetag: 14.04.2008
(51) Int. Cl.: B29C 33/00, B29C 45/14, H01L 33/00, H01L 21/56

(54) **VERFAHREN ZUR HERSTELLUNG EINES OPTOELEKTRONISCHEN BAUELEMENTES UND OPTOELEKTRONISCHES BAUELEMENT**
METHOD FOR PRODUCING AN OPTO-ELECTRONIC COMPONENT AND OPTO-ELECTRONIC COMPONENT
PROCÉDÉ DE FABRICATION D'UN COMPOSANT OPTOÉLECTRONIQUE ET COMPOSANT OPTOÉLECTRONIQUE

(30) Priorität: 16.04.2007 DE 102007017855
(43) Veröffentlichungstag der Anmeldung: 30.12.2009
(73) Patentinhaber: OSRAM Opto Semiconductors GmbH, 93055 Regensburg (DE)
(72) Erfinder: JAEGER, Harald, 93049 Regensburg (DE); BRUNNER, Herbert, 93161 Sinzing (DE); SCHNEIDER, Albert, 93107 Thalmassing (DE); ZEILER, Thomas, 93152 Nittendorf (DE)
(74) Vertreter: Epping - Hermann - Fischer
(86) Internationale Anmeldenummer: PCT/DE2008/000626
(87) Internationale Veröffentlichungsnummer: WO 2008/125096

(56) Entgegenhaltungen:
- WO-A-2007/007959
- JP-A- 5 063 239
- JP-A- 5 218 508
- JP-A- 61 283 134
- JP-A- 2002 329 892
- US-A1- 2003 168 720
- US-A1- 2004 108 614
- US-A1- 2006 105 484
- ZECHER R F ET AL: "ENCAPSULATION OF ELECTRICAL COMPONENTS UTILIZING LIQUID RESIN MOLDING TECHNIQUES" SPE JOURNAL, SOCIETY OF PLASTICS ENGINEERS INC. GREENWICH, US, Bd. 25, Nr. 2, 1. Februar 1969 (1969-02-01), Seiten 40-44, XP001173684

## Beschreibung

Die Erfindung betrifft ein Verfahren zur Herstellung eines optoelektronischen Bauelementes und ein optoelektronisches Bauelement.

Zur Anpassung der Abstrahlcharakteristik von optoelektronischen Bauelementen an vorgegebene Werte können optische Elemente, wie etwa Linsen, eingesetzt werden. Ein solches optoelektronisches Bauelement ist beispielsweise in der Druckschrift DE 10 2005 020 908 A1 beschrieben. Bei diesem Bauelement wird auf einen strahlungserzeugenden Halbleiterkörper, der in einem Gehäuse montiert ist, eine vorgefertigte Linse aufgesetzt. Vor dem Aufsetzen der vorgefertigten Linse wird der Halbleiterkörper mit einer Umhüllung vergossen, die dem Schutz des Halbleiterkörpers dienen soll. Die Linse wird bei diesem optoelektronische Bauelement separat gefertigt und in einem zusätzlichen Montageprozess befestigt. Hierdurch entstehen zusätzlicher Montageaufwand und zusätzliche potentielle Fehlerquellen.

Die Druckschrift US 2006/0105484 A1 betrifft ein Verfahren zur Herstellung eines optoelektronischen Bauelementes, bei dem eine Linse über einem LED-Chip mittels Overmolding angeformt wird. Die Druckschrift JP 05-063239 A behandelt eine LED mit einem Leiterrahmen, die von einer Umhüllung in Form einer Linse umgeben ist. Die Druckschrift US 2003/0168720 A1 betrifft die Herstellung eines optoelektronischen Bauelementes mit einem Halbleiterkörper, über den eine Linse unter Verwendung einer geschlossenen Kavität, beispielsweise mittels eines Spritzgussprozesses, angeformt wird. Die Druckschrift JP 61283234 A betrifft die Herstellung einer Licht emittierenden Diode, wobei eine Umhüllung in Form einer Linse unter Verwendung einer geschlossenen Form ausgebildet wird. Die Druckschrift WO 2007/007959 behandelt die Herstellung eines Licht emittierenden Halbleiterbauelementes, wobei eine Umhüllung in Form einer Linse mit Hilfe eines geschlossenen Werkzeugs ausgebildet wird. Die Druckschrift JP 5218508 A betrifft ein optoelektronisches Bauelement mit einem Halbleiterkörper, der auf einem Substrat angebracht ist und über dem ein domartig ausgebildeter, transparenter Verguss angeordnet ist. Die Druckschrift JP 2002329892 A betrifft die Herstellung eines optoelektronischen Bauelementes mit einem Licht emittierenden Halbleiterkörper, der auf einem Substrat aufgebracht ist, wobei ein Dichtelement,das auf dem Substrat aufgebracht ist und direkt mit der Umhüllung abschließt, vorgesehen ist. Die Druckschrift US 2004/0108614 A behandelt die Herstellung einer akustischen Barriere für ein Motorfahrzeug, wobei beim Schließen eines Formwerkzeugs ein seitlich angebrachtes Dichtungselement komprimiert wird.

Aufgabe der Erfindung ist es, ein verbessertes Herstellungsverfahren für ein optoelektronisches Bauelement anzugeben. Weiterhin ist es Aufgabe der Erfindung, ein optoelektronisches Bauelement mit vereinfachtem Herstellungsverfahren anzugeben.

Diese Aufgaben werden durch ein Verfahren mit den Schritten des Patentanspruches 1 und ein optoelektronisches Bauelement mit den Merkmalen des Patentanspruches 13 gelöst.

Vorteilhafte Ausgestaltungen und Weiterbildungen der Erfindung sind in den jeweils abhängigen Patentansprüchen angegeben.

Ein Verfahren zur Herstellung eines optoelektronischen Bauelementes weist insbesondere die folgenden Schritte auf:
- Bereitstellen eines Substrates mit einer ersten Hauptfläche und einer zweiten Hauptfläche, die der ersten Hauptfläche gegenüberliegt,
- Befestigen eines Halbleiterkörpers, der geeignet ist, elektromagnetische Strahlung von einer Vorderseite zu emittieren, auf der ersten Hauptfläche des Substrates, und
- Aufbringen einer Umhüllung, die durchlässig ist für Strahlung des optoelektronischen Halbleiterkörpers, zumindest über der Vorderseite des Halbleiterkörpers, bei dem die Umhüllung als optisches Element ausgebildet wird unter Verwendung eines Werkzeuges mit einer geschlossenen Kavität, die die Kontur des optischen Elementes aufweist.
Das Substrat weist auf seiner ersten Hauptfläche zumindest ein Dichtelement auf, das umlaufend um den Bereich der ersten Hauptfläche ausgebildet ist, auf den das optische Element aufgebracht wird und das mit dem optischen Element seitlich abschließt. Das Dichtelement weist einen Querschnitt auf, der zumindest teilweise dreieckig, trapezförmig oder nach Art einer Ellipse ausgebildet ist.

Bei dem optischen Element kann es sich beispielsweise um eine Linse handeln.

Bei diesem Verfahren kann die Umhüllung direkt angrenzend an die Vorderseite des optoelektronischen Halbleiterkörpers angeordnet werden oder beabstandet von dieser. Im letzteren Fall kann zwischen der Umhüllung und der Vorderseite des Halbleiterkörpers eine zusätzliche Schicht angeordnet sein, beispielsweise eine wellenlängenkonvertierende Schicht. Diese Schicht wird weiter unten näher erläutert.

Weiterhin ist es auch möglich, dass das Substrat zumindest teilweise von der Umhüllung umschlossen wird.

Das vorliegende Verfahren bietet den Vorteil, Umhüllung und optisches Element zur Formung der Abstrahlcharakteristik in einem Verfahrensschritt herzustellen, das optische Element ist also in das optoelektronische Bauelement integriert und nicht separat gefertigt. Auf diese Art und Weise wird der Herstellungsprozess des optoelektronischen Bauelementes vereinfacht und die Anzahl der Fehlerquellen bei der Herstellung verringert.

Bevorzugt wird die Umhüllung mittels eines Kunststoffverarbeitungsprozesses aufgebracht, der besonders bevorzugt massenfertigungstauglich ist. Ein massenfertigungstauglicher Kunststoffverarbeitungsprozess ermöglicht in der Regel eine günstigere Herstellung als beispielsweise manuelle oder halbmanuelle Gießverfahren. Bei dem Kunststoffverarbeitungsprozess kann es sich beispielsweise um Compression Molding, Liquid Injection Molding-Spritzguss (LIM-Spritzguss), Liquid Transfer Molding oder Vergießen handeln.

LIM-Spritzguss ermöglicht vorteilhafterweise die massenfertigungstaugliche Spritzgießverarbeitung von flüssigen Kunststoffmaterialien, wie beispielsweise silikonhaltigen Kunststoffmaterialien, die besonders gut für optische Elemente geeignet sind.

Die Vorrichtung für LIM-Spritzguss umfasst in der Regel zumindest einen Vorratsbehälter für ein flüssiges Kunststoffmaterial und eine Pumpe, die das Kunststoffmaterial von dem Vorratsbehälter zu einem Dosiersystem transportiert. Als Dosiersystem können beispielsweise eine Schnecke, ein Kolbendosierer, ein statischer Mischer oder ein statisch-dynamischer Mischer verwendet werden. Es können auch ein oder mehrere weitere Spritzgießbehälter von der Vorrichtung umfasst sein, beispielsweise um zwei- oder mehrkomponentige Kunststoffmaterialien zu verarbeiten. Die geschlossene Kavität mit der Kontur des optischen Elementes ist hierbei in der Regel durch ein Werkzeug gebildet. Das Werkzeug umfasst in der Regel zumindest zwei Werkzeugteile, von denen zumindest ein Teil die Kavität mit der Kontur des optischen Elementes aufweist. Das Substrat mit dem optoelektronischen Halbleiterkörper wird hierbei beispielsweise in den einen Teil des Werkzeugs eingelegt, während ein weiterer Teil des Werkzeuges gegenüberliegend angeordnet ist und die Kavität mit der Kontur des optischen Elementes aufweist. Wird das Werkzeug geschlossen, wird auch die Kavität geschlossen, entweder in dem der eine Teil des Werkzeuges auf dem Substrat oder auf einem weiteren Teil des Werkzeuges abdichtet. Bei geschlossener Kavität findet der Einspritzvorgang statt, der das Kunststoffmaterial in die Kavität transportiert, beispielsweise durch ein Angusssystem des Werkzeuges hindurch. In der Regel ist das Dosiersystem bei diesem Kunststoffverarbeitungsprozess parallel zu einer Achse der Vorrichtung angeordnet. In der Regel ist das Werkzeug mit der geschlossenen Kavität ebenfalls auf dieser Achse angeordnet.

Beim LIM-Spritzguss werden neben ein- oder mehrkomponentigen flüssigen Materialien auch vernetzende Werkstoffe, wie beispielsweise Duroplaste, verarbeitet. Zur Verarbeitung von Duroplasten wird das Werkzeug in der Regel beheizt. Bei der Verarbeitung von Silikonen treten in der Regel geringere Nachdrücke auf als bei der Verarbeitung von Thermoplasten. Weiterhin ist auch eine Kombination von LIM-Spritzguss und Thermoplastverarbeitung möglich.

Bei einer weiteren Ausgestaltung des Verfahrens wird als Kunststoffverarbeitungsprozess Compression Molding verwendet. Beim Compression Molding wird das Substrat mit seiner zweiten Hauptfläche auf einen Teil des Werkzeuges aufgespannt oder in diesen eingelegt, während ein weiterer Teil des Werkzeuges, der die Kavität mit der Kontur des optischen Elementes aufweist, gegenüber angeordnet ist. Im Unterschied zum LIM-Spritzguss findet der Einspritzvorgang jedoch bei geöffnetem Werkzeug statt. Hierzu ist das Dosiersystem - in der Regel ein statischer oder ein statisch-dynamischer Mischer - zweckmäßigerweise seitlich des Werkzeuges angeordnet und befüllt die Kavitäten mit der Kontur des optischen Elementes direkt mit dem Kunststoffmaterial. Beim Schließen des Werkzeuges wird das Kunststoffmaterial in die Kavität gedrückt und füllt diese aus.

Beim Transfer Molding wird die Menge des Kunststoffmaterials, die für das Befüllen der Kavität benötigt wird, vor dem Einbringen in das Werkzeug abgemessen und in einen separaten Behälter eingebracht. Von diesem Behälter wird das Kunststoffmaterial bei geschlossenem Werkzeug mit Hilfe eines Dosiersystems, beispielsweise eines Kolben, in die Kavität transportiert. Beim Liquid Transfer Molding wird auf diese Art und Weise ein flüssiges Kunststoffmaterial, wie beispielsweise ein Silikonmaterial, verarbeitet.

Bei einer Ausführungsform des Verfahrens wird eine Folie in das Werkzeug eingebracht, bevorzugt vor dem Einspritzen des Kunststoffmaterials in die Kavität. Besonders bevorzugt grenzt die Folie hierbei direkt an die Kavität an, die die Kontur des optischen Elementes aufweist. Dies kann beispielsweise mit Hilfe eines Vakuums erreicht werden. In der Regel wird das Kunststoffmaterial für die Umhüllung zwischen Folie und Substrat in die Kavität eingebracht. Ist die Umhüllung ausgebildet, wird das Werkzeug wieder geöffnet und die Folie in der Regel wieder entfernt.

Mit Hilfe der Folie wird vorteilhafterweise verhindert, dass das Kunststoffmaterial das Werkzeug berührt und dort haften bleibt. Weiterhin bietet die Verwendung der Folie den Vorteil, Unebenheiten des Substrates ausgleichen zu können und so Verunreinigungen des Substrates mit Kunststoffmaterial zumindest zu verringern. Die Folie weist bevorzugt eine Dicke zwischen 20 µm und 100 µm auf, wobei die Grenzen eingeschlossen sind. Die Folie kann beispielsweise Ethylen-Tetrafluorethylen (ETFE) aufweisen oder aus diesem Material bestehen.

Da das Werkzeug in der Regel beheizt wird, wird bevorzugt eine temperaturbeständige Folie verwendet, die besonders bevorzugt für Temperaturen zwischen 100°C und 150°C beständig ist, wobei die Grenzen eingeschlossen sind.

Alternativ oder zusätzlich zu einer Folie, kann das Haften des Kunststoffmaterials an dem Werkzeug mit Hilfe einer Beschichtung des Werkzeuges zumindest vermindert werden. So kann das Werkzeug innerhalb der Bereiche beschichtet sein, die mit dem Kunststoffmaterial in Berührung kommen. Als Beschichtung eignet sich beispielsweise eine Schicht, die Ni-PTFE aufweist oder aus diesem Material besteht.

Besonders bevorzugt wird für die Umhüllung ein Silikon oder ein Hybridmaterial als Kunststoffmaterial verwendet. Als Hybridmaterial wird hierbei ein Material bezeichnet, das mindestens zwei Hauptkomponenten aufweist, wobei eine dieser Hauptkomponenten ein Silikon ist. Neben den Hauptkomponenten kann das Kunststoffmaterial weitere Bestandteile als Hilfsstoffe aufweisen, wie etwa Stoffe zur Vermeidung vom Vergilben (Blaumacher), Weichmacher oder Entformungshilfsstoffe. Solche Bestandteile haben jedoch in der Regel geringen Masseanteil an dem Kunststoffmaterial. Der überwiegende Teil des Kunststoffmaterials weist die Hauptkomponenten auf.

Die Verwendung von Silikonen als Umhüllung bietet den Vorteil, dass diese besonders temperatur- und UV-stabil sind, sowie eine hohe Durchlässigkeit für sichtbare Strahlung aufweisen.

Besonders bevorzugt weist das Hybridmaterial ca. 50% Silikon und ca. 50% Prozent (bezogen auf die Masse) Epoxydharz auf.

Bei einer weiteren Ausführungsform des Verfahrens weist das Hybridmaterial zwischen 10 % und 70 % (bezogen auf die Masse) Epoxydharz auf, wobei die Grenzen eingeschlossen sind.

Es versteht sich, dass bei den obigen Angaben, das Verhältnis der Hauptkomponenten zueinander gemeint ist und etwaige Anteile an Hilfsstoffen nicht berücksichtigt sind.

Gemäß einer weiteren Ausführungsform des Verfahrens weist das Kunststoffmaterial einen Haftvermittler auf, der die Haftung zwischen der Umhüllung und dem Substrat bzw. dem Halbleiterkörper verbessert.

Als Substrat kann beispielsweise ein vorgeformtes Gehäuse, ein vorgeformter Leadframe, ein vorgeformter Leadframe mit Wärmesenke oder ein Printed Circuit Board (PCB) verwendet werden. Weiterhin kann das Substrat Keramik oder Kupfer aufweisen oder aus einem dieser Materialien bestehen. Beispielsweise kann als Substrat Direct Bonded Copper (DBC-Substrat) verwendet werden. Ein DBC-Substrat umfasst einen Kern, beispielsweise aus einer Keramikplatte und ein oder zwei Kupferplatten, die mit dem Kern verbunden sind. Ein DBC-Substrat weist insbesondere eine hohe thermische Leitfähigkeit auf. Weiterhin kann der thermische Ausdehnungskoeffizient des DBC-Substrates an den thermischen Ausdehnungskoeffizienten eines Halbleiterkörpers angepasst werden.

Ein vorgeformtes Gehäuse kann beispielsweise einen Leadframe mit zumindest zwei Anschlussstreifen und einen Gehäusekörper aufweisen, wobei der Gehäusekörper bevorzugt aus einer Pressmasse um den Leadframe herum ausgeformt- beispielsweise gespritzt, gepresst oder spritzgepresst - ist. Die Pressmasse kann beispielsweise farbig, weiß oder schwarz ausgebildet sein und ein Epoxid mit Füllstoffen, ein Silikon mit Füllstoffen oder ein Hybridmaterial mit Silikon und Epoxid aufweisen oder aus einem dieser Materialien bestehen. Der Leadframe weist hierbei bevorzugt Verankerungspunkte auf seiner Oberfläche auf, die beispielsweise durch Ätzen hergestellt sind, und der Verankerung zwischen Leadframe und Gehäusekörper dienen.

Als Substrat kann auch ein strukturierter metallischer Leadframe verwendet werden, der zur mechanischen Fixierung in dem Werkzeug zumindest einen Durchbruch aufweist. Ein solcher strukturierter Leadframe weist bevorzugt Tape, beispielsweise eine Klebefolie, auf der zweiten Hauptfläche auf, um Verunreinigungen mit Kunststoffmaterial zu vermeiden.

Bei einer Ausführungsform des Verfahrens wird als Halbleiterkörper ein Dünnfilmhalbleiterchip verwendet. Als Dünnfilmhalbleiterchip wird vorliegend ein Halbleiterkörper bezeichnet, der eine epitaktisch gewachsene, strahlungserzeugende Halbleiterschichtenfolge aufweist, wobei ein Aufwachssubstrat entfernt oder derart gedünnt wurde, dass es den Dünnfilmhalbleiterchip alleine nicht mehr ausreichend mechanisch stabilisiert. Die Halbleiterschichtenfolge des Dünnfilmhalbleiterchips ist daher bevorzugt auf einem Träger angeordnet, der den Halbleiterkörper mechanisch stabilisiert und besonders bevorzugt vom Aufwachssubstrat für die Halbleiterschichtenfolge des Halbleiterkörpers verschieden ist. Weiterhin ist bevorzugt zwischen dem Träger und der strahlungserzeugenden Halbleiterschichtenfolge eine reflektierende Schicht angeordnet, die die Aufgabe hat, die Strahlung der Halbleiterschichtenfolge zur strahlungsemittierenden Vorderseite des Dünnfilmhalbleiterchips zu lenken. Die strahlungserzeugende Halbleiterschichtenfolge weist weiterhin bevorzugt eine Dicke im Bereich von zwanzig Mikrometer oder weniger, insbesondere im Bereich von zehn Mikrometer auf.

Das Grundprinzip eines Dünnfilmhalbleiterchips ist beispielsweise in der Druckschrift I. Schnitzer et al., Appl. Phys. Lett. 63 , 16 ,18. Oktober 1993, Seiten 2174 - 2176 beschrieben. Beispiele für Dünnfilm-Leuchtdiodenchips sind in den Druckschriften EP 0905797 A2 und WO 02/13281 A1 beschrieben, deren Offenbarungsgehalt insofern hiermit ebenfalls durch Rückbezug aufgenommen wird.

Ein Dünnfilmhalbleiterchip ist in guter Näherung ein Lambertscher Oberflächenstrahler. Daher kann es vorteilhaft sein, ein optoelektronisches Bauelement mit einem Dünnfilmhalbleiterchip als strahlungserzeugenden Halbleiterkörper mit einem optischen Element zu versehen, um die Abstrahlcharakteristik des optoelektronischen Bauelementes gezielt zu beeinflussen.

Bei einer weiteren Ausgestaltung des Verfahrens wird auf die Vorderseite des Halbleiterkörpers eine wellenlängenkonvertierende Schicht aufgebracht. Die wellenlängenkonvertierende Schicht weist zumindest einen Wellenlängenkonversionsstoff auf, der Strahlung des Halbleiterkörpers eines ersten Wellenlängenbereiches in Strahlung eines vom ersten Wellenlängenbereich verschiedenen zweiten Wellenlängenbereich konvertiert. In der Regel ist die konvertierte Strahlung des zweiten Wellenlängenbereiches hierbei langwelliger als die unkonvertierte Strahlung des ersten Wellenlängenbereiches.

Eine wellenlängenkonvertierende Schicht ist beispielsweise in der Druckschrift WO 97/50132 beschrieben.

Der Wellenlängenkonversionsstoff ist beispielsweise aus der Gruppe gewählt, die durch die folgenden Stoffe gebildet wird: Mit Metallen der seltenen Erden dotierte Granate, mit Metallen der seltenen Erden dotierte Erdalkalisulfide, mit Metallen der seltenen Erden dotierte Thiogalate, mit Metallen der seltenen Erden dotierte Aluminate, mit Metallen der seltenen Erden dotierte Orthosilikate, mit Metallen der seltenen Erden dotierte Chlorosilikate, mit Metallen der seltenen Erden dotierte Erdalkalisiliziumnitride, mit Metallen der seltenen Erden dotierte Oxynitride und mit Metallen der seltenen Erden dotierten Aluminiumoxynitride.

Besonders bevorzugt wird als Wellenlängenkonversionsstoff ein Ce-dotierte YAG-Wellenlängenkonversionsstoff (YAG:Ce) verwendet.

Partikel des Wellenlängenkonversionsstoffes können in ein Bindemittel eingebettet sein. Das Bindemittel kann aus der Gruppe ausgewählt sein, die durch die folgenden Materialien gebildet wird: Thermoplastische Materialien, Polystyrol, Latex, transparente Gummisorten, Glas, Polycarbonat, Acrylat, Teflon, Silicate, Wasserglas, Polyvinyl, Silikon, Epoxydharz, PMMA oder Hybridmaterialien mit Silikonen, Epoxydharzen beziehungsweise PMMA.

Gemäß einer Ausführungsform des Verfahrens wird die Dicke der wellenlängenkonvertierenden Schicht bzw. die Konzentration des Wellenlängenkonversionsstoffes derart gewählt, dass ein Teil der elektromagnetischen Strahlung des ersten Wellenlängenbereiches, der von dem Halbleiterkörper emittiert wird, unkonvertiert durch die wellenlängenkonvertierende Schicht hindurch läuft. In diesem Fall mischen sich unkonvertierte Strahlung des ersten Wellenlängenbereiches und konvertierte Strahlung des zweiten Wellenlängenbereiches, sodass das optoelektronische Bauelement Mischstrahlung aus Strahlung des ersten Wellenlängenbereiches und Strahlung des zweiten Wellenlängenbereiches aussendet. Auf diese Art und Weise ist es möglich, ein optoelektronisches Bauelement herzustellen, das Mischlicht mit einem Farbort im weißen Bereich der CIE-Normfarbtafel emittiert. Hierzu wird beispielsweise ein Halbleiterkörper verwendet, der elektromagnetische Strahlung aus dem blauen Spektralbereich aussendet und ein Wellenlängenkonversionsstoff, der einen Teil dieser blauen Strahlung des ersten Wellenlängenbereiches in gelbe Strahlung umwandelt. Ein Wellenlängenkonversionsstoff, der hierzu geeignet ist, ist beispielsweise YAG:Ce.

Bei einer besonders bevorzugten Ausführungsform des Verfahrens wird auf die erste Hauptfläche des Substrates eine Dichtungsschicht aufgebracht. Besonders bevorzugt wird die Dichtungsschicht auf den Teil der ersten Hauptfläche aufgebracht, der dafür vorgesehen ist, während des Verfahrens mit dem Teil des Werkzeugs, der die Kontur des optischen Elementes aufweist, in Kontakt zu stehen, so dass die Dichtungsschicht bei geschlossenem Werkzeug zumindest teilweise eine gemeinsame Grenzfläche mit dem Werkzeug ausbildet. Besonders bevorzugt ist der Bereich der ersten Hauptfläche des Substrates, auf den das optische Element aufgebracht wird, frei von der Dichtungsschicht. Bei einer Ausgestaltung haben die Dichtungsschicht und das optische Element eine gemeinsame Grenzfläche.

Die Dichtungsschicht ist insbesondere dazu vorgesehen, Rauhigkeiten des Substrates auszugleichen und so zu einem dichteren Schließen der Kavität beizutragen. Auf diese Art und Weise können Verunreinigungen des Substrates während des Kunststoffverarbeitungsprozesses vermieden werden, wie sie insbesondere bei Verwendung dünnflüssiger Kunststoffmaterialien, etwa Silikonen, entstehen können. Insbesondere, wenn sich Verunreinigungen in Bereichen des Substrates befinden, die zur späteren Kontaktierung des optoelektronischen Halbleiterbauelementes dienen sollen, ist ansonsten eine Entfernung der Verunreinigungen in separaten Verfahrensschritten notwendig. Weiterhin kann die Dichtungsschicht auch die Funktion eines Haftvermittlers zwischen dem Kunststoffmaterial und dem Substrat übernehmen. Hierzu ist die Dichtungsschicht zweckmäßigerweise zumindest teilweise auch auf den Bereich der ersten Hauptseite des Substrates aufgebracht, auf den die Umhüllung aufgebracht wird. Bei dieser Ausgestaltung haben das optische Element und die Dichtungsschicht vorzugsweise eine gemeinsame Grenzfläche.

Bevorzugt ist die Dichtungsschicht flexibel und weich ausgebildet, sodass sie beim Schließen des Werkzeuges nachgibt, aber durch den aufgebrachten Schließdruck nicht vom Substrat entfernt oder beschädigt wird. Besonders bevorzugt weist die Dichtungsschicht eine Dicke zwischen 5 *µ*m und 100 *µ*m auf, wobei die Grenzen eingeschlossen sind. Weiterhin weist die Dichtungsschicht bevorzugt Shorehärten zwischen A30 und 90 auf, wobei wiederum die Grenzen eingeschlossen sind.

Die Dichtungsschicht kann durch ein Druckverfahren, wie beispielsweise Siebdruck, Tampondruck oder Inkjet-Druck aufgebracht werden.

Die Dichtungsschicht kann beispielsweise Polyimid oder Silikon aufweisen oder aus einem dieser Materialien bestehen.

Weiterhin kann die Dichtungsschicht beispielsweise einen Trockenresist aufweisen oder aus diesem Material bestehen. Eine Dichtungsschicht, die Trockenresist aufweist oder aus diesem Material besteht, wird zweckmäßigerweise mit Hilfe eines lithographischen Verfahrens auf die erste Hauptfläche des Substrates aufgebracht.

Bei einer weiteren Ausgestaltung des Verfahrens wird als Dichtungsschicht eine Metallisierung auf das Substrat aufgebracht. Die Metallisierung weist bevorzugt eines der folgenden Materialien auf oder besteht aus einem dieser Materialien: Silber, Gold, Kupfer, Zinn. Besonders bevorzugt ist die Metallisierung nicht dicker als 30 *µ*m.

Bei einer weiteren bevorzugten Ausführungsform des Verfahrens wird die Dichtungsschicht strukturiert auf das Substrat aufgebracht. Dies ermöglicht vorteilhafterweise, dass Luft aus der geschlossenen Kavität entweichen kann. Dies erleichtert die Füllung der Kavität mit Kunststoffmaterial und führt daher zu einer besseren Abformung der Kavität.

Weiterhin kann die Dichtungsschicht auch eine Folie sein, die beispielsweise strukturiert auf das Substrat aufgebracht wird. Die Folie kann in dem Bauteil verbleiben oder aber auch zumindest teilweise wieder von dem Substrat entfernt werden.

Gemäß einer Ausführungsform kann die Dichtungsschicht einen Haftvermittler umfassen, der die Haftung zwischen Dichtungsschicht und Substrat verbessert.

Bei einer weiteren Ausführungsform des Verfahrens weist der Formkern des Werkzeuges einen Entlüftungskanal auf. Hierdurch kann vorteilhafterweise ebenfalls eine Entlüftung des geschlossenen Werkzeuges während des Kunststoffverarbeitungsprozesses erzielt werden.

Weiterhin kann auch eine Oberfläche des Formkernes derart zurückgesetzt sein, dass diese zusammen mit einer Oberfläche des Substrates oder der Dichtungsschicht einen Entlüftungskanal ausbildet.

Bei einer weiteren Ausgestaltung des Verfahrens werden das Werkzeug und insbesondere die Kavität mit der Kontur des optischen Elementes vor dem Einspritzvorgang evakuiert. Ein Evakuieren des Werkzeuges führt in der Regel vorteilhafterweise zu einer besonders guten Füllung der Kavitäten.

Bei einer weiteren Ausgestaltung des Verfahrens werden mehrere Halbleiterkörper, die geeignet sind, elektromagnetische Strahlung zu erzeugen, auf der ersten Hauptfläche des Substrates aufgebracht. Dann wird eine Umhüllung, die durchlässig ist für Strahlung des optoelektronischen Halbleiterkörpers, zumindest über der Vorderseite der Halbleiterkörper aufgebracht, bei dem die Umhüllung als optisches Element ausgebildet wird unter Verwendung einer geschlossenen Kavität, die die Kontur des optischen Elementes aufweist. Nach dem Aufbringen der Umhüllung wird das Substrat in separate Bauteile vereinzelt. Dies ermöglicht die parallele Fertigung mehrerer optoelektronischer Bauteile. Auf diese Art und Weise können die Prozesszeiten für ein Bauteil deutlich verkürzt werden.

Bei einer weiteren Ausgestaltung des Verfahrens werden mehrere Substrate auf einer Rolle aufgebracht (Rolle-zu-Rolle-Prozess). Weiterhin ist es auch möglich, dass die Substrate auf einem Trägerband angeordnet werden, das zu einer Rolle aufgerollt wird.

So können ebenfalls mehrere Bauteile parallel gefertigt werden, wobei insbesondere bei Verwendung eines Kunststoffverarbeitungsprozesse zur Aufbringung der Umhüllung die Handhabung der zu fertigenden Bauteile vereinfacht ist, da die Rolle durch den Kunststoffverarbeitungsprozess geführt werden kann. Auf diese Art und Weise kann beispielsweise auf Pick-and-Place-Vorrichtungen zur Handhabung der Bauteile verzichtet werden.

Bei einem Rolle-zu-Rolle-Prozess wird bevorzugt ein Platzhalter auf der Rolle angebracht. Auf diese Art und Weise kann eine Beschädigung des Halbleiterkörpers oder dessen elektrischen Kontakten beim Verarbeitungsprozess vermieden werden.

Bei einer weiteren Ausgestaltung des erfindungsgemäßen Verfahrens weist das Substrat auf seiner ersten Hauptfläche zumindest eine Erhebung auf, die vorzugsweise domartig ausgebildet ist. Besonders bevorzugt ist die Erhebung in dem Bereich der ersten Hauptfläche des Substrates angeordnet, auf dem die Umhüllung angeordnet wird. Mithilfe dieser Erhebung kann eine bessere Verankerung zwischen Substrat und Umhüllung erzielt werden.

Weiterhin kann das Substrat auf seiner ersten Hauptfläche eine Struktur als Zentrierhilfe für den Formkern des Werkzeuges aufweisen. Diese Struktur ist bevorzugt auf dem Bereich der ersten Hauptfläche des Substrates angeordnet, der während des Schließens des Werkzeuges, das die Kontur des optischen Elementes aufweist, außerhalb des Werkzeuges liegt. Besonders bevorzugt ist die Zentrierhilfe derart auf der ersten Hauptfläche des Substrates angeordnet, dass das Werkzeug mit der Kontur des optischen Elementes von der Zentrierhilfe bündig umschlossen wird.

Besonders bevorzugt bildet das Dichtelement eine geschlossene Form aus, dass heißt, dass das Dichtelement frei von Durchbrüchen ist. Das Dichtelement kann beispielsweise einen geschlossenen Ring - etwa einen Kreisring - um das optische Element ausbilden. Insbesondere haben das optische Element und das Dichtelement eine gemeinsame Grenzfläche.

Das Dichtelement hat die Aufgabe, die Kavität, die die Kontur des optischen Elementes aufweist, bei geschlossenem Werkzeug abzudichten. Das Dichtelement schließt daher bevorzugt mit zumindest dem Teil des Werkzeuges, das die Kontur des optischen Elementes aufweist, dicht ab. Besonders bevorzugt schließt das Dichtelement derart dicht mit dem Teil des Werkzeuges ab, das die Kontur des optischen Elements aufweist, dass kein oder für die Funktion des Bauelementes vernachlässigbar wenig Kunststoffmaterial während des Einspritzvorganges aus der Kavität dringt.

Besonders bevorzugt gleicht das Dichtelement Form- Flächen und Maßtoleranzen des Werkzeuges und/oder des Substrates aus.

Bei dem Dichtelement kann es sich beispielsweise um eine Dichtlippe handeln.

Weiterhin weist das Dichtelement bevorzugt ein elastisches Material auf. Ein elastisches Dichtelement kann mit Vorteil beim Schließen des Werkzeuges verformt werden, so dass eine besonders gute Dichtung zwischen Werkzeug und Dichtelement entsteht. Insbesondere weist das Substrat gegenüber dem Dichtelement ein hartes Material auf, so dass das Substrat selber beim Schließen des Werkzeuges nicht verformt wird.

Ein elastisches Dichtelement kann beispielsweise zumindest eines der folgenden Materialien aufweisen oder aus zumindest einem der folgenden Materialien bestehen: Silikone, elastomerische Kunststoffe, Lacke, wie beispielsweise Lötstopplacke.

Das Dichtelement ist beispielsweise auf die erste Hauptfläche des Substrates aufgeklebt oder aufgedruckt.

Weiterhin kann das Dichtelement auch in das Substrat eingearbeitet sein. Weisen Dichtelement und Substrat unterschiedliche Materialien auf, so kann das Dichtelement beispielsweise mittel Mehrkomponentenspritzguss in das Substrat eingearbeitet werden. Weiterhin ist es auch möglich, dass das Substrat eine Nut aufweist, in die das Dichtelement eingesetzt wird.

Ein optoelektronisches Bauelement, das beispielsweise gemäß dem hier beschriebenen Verfahren hergestellt werden kann, umfasst insbesondere:
- ein Substrat mit einer ersten Hauptfläche und einer zweiten Hauptfläche, die der ersten Hauptfläche gegenüberliegt,
- einen Halbleiterkörper, der geeignet ist, elektromagnetische Strahlung von einer Vorderseite auszusenden, auf der ersten Hauptfläche des Substrates, und
- eine Umhüllung über der Vorderseite des Halbleiterkörpers, die als optisches Element ausgebildet ist und in das optische Bauelement integriert ist, wobei das Substrat auf seiner ersten Hauptfläche zumindest ein Dichtelement aufweist, das umlaufend um den Bereich der ersten Hauptfläche ausgebildet ist, auf den das optische Element aufgebracht wird und das mit dem optischen Element seitlich abschließt, und wobei das Dichtelement einen Querschnitt aufweist, der zumindest teilweise dreieckig, trapezförmig oder nach Art einer Ellipse ausgebildet ist.

Bevorzugt sind die erste und die zweite Hauptfläche zumindest teilweise planparallel zueinander angeordnet. Besonders bevorzugt sind Teile der beiden Hauptflächen, über denen das optische Element angebracht wird, planparallel zueinander angeordnet.

Weist das optoelektronische Bauelement ein Dichtelement auf, so ist dieses besonders bevorzugt auf dem planparallelen Bereich der ersten Hauptfläche des Substrates angeordnet.

Da der strahlungserzeugende Halbleiterkörper des optoelektronischen Bauelementes auf ein Substrat aufgebracht ist, das zwei gegenüberliegende, insbesondere teilweise planparallele Hauptflächen aufweist, kann zur Aufbringung der Umhüllung eine geschlossene Kavität mit der Kontur des optischen Elementes verwendet werden, da das Substrat mit dem Halbleiterkörper geeignet ist, als Einlegeteil in die Kavität eingelegt zu werden. Ein Substrat, das beispielsweise neben einer Montagefläche für den Halbleiterkörper weiter Elemente aufweist, die bezüglich der Hauptflächen gekippt angeordnet sind, wie beispielsweise elektrische Anschlussteile, ist hierzu nicht geeignet, da die Kavität mit der Kontur des optischen Elementes nicht geschlossen werden kann.

Bei einer Ausgestaltung des optoelektronischen Bauelements ist zwischen der Vorderseite des Halbleiterkörpers und der Umhüllung eine wellenlängenkonvertierende Schicht angeordnet.

Bei einer weiteren Ausgestaltung weist die Umhüllung ein Silikon oder ein Hybridmaterial auf. Bei einer Weiterbildung weist das Hybridmaterial 50% Silikon und 50% Epoxidharz auf. Bei einer anderen Weiterbildung weist das Hybridmaterial zwischen 10% und 70% Epoxidharz auf, wobei die Grenzen eingeschlossen sind.

Bei einer anderen Ausgestaltung des optoelektronischen Bauelements ist als Substrat ein vorgeformtes Gehäuse, ein vorgeformter Leadframe, ein vorgeformter Leadframe mit Wärmesenke oder eine gedruckte Leiterplatte (Printed Circuit Board, PCB) verwendet. Bei einer Weiterbildung weist das Substrat Keramik und/oder Kupfer auf.

Bei einer weiteren Ausgestaltung ist der Halbleiterkörper ein Dünnfilmhalbleiterchip.

Bei einer wiederum anderen Ausgestaltung des optoelektronischen Bauelements ist auf die erste Hauptfläche des Substrates eine Dichtungsschicht aufgebracht. Die Dichtungsschicht weist beispielsweise Trockenresist auf. Alternativ kann als Dichtungsschicht auch eine Metallisierung aufgebracht sein. Die Dichtungsschicht ist bei einer Weiterbildung strukturiert aufgebracht.

Bei einer vorteilhaften Ausgestaltung des optoelektronischen Bauelements weist das Substrat auf seiner ersten Hauptfläche mindestens eine Erhebung aufweist, die vorzugsweise domartig ausgebildet ist.

Das Substrat weist bei einer Ausgestaltung auf seiner ersten Hauptfläche eine Struktur als Zentrierhilfe für den Formkern auf.

Insbesondere haben das Dichtelement und das optische Element eine gemeinsame Grenzfläche. Bei einer Ausgestaltung weist das Dichtelement ein elastisches Material auf. Bei einer anderen Ausgestaltung ist das Dichtelement auf die erste Hauptfläche des Substrates aufgeklebt, aufgedruckt oder in das Substrat eingearbeitet.

Weitere Merkmale, vorteilhafte Ausgestaltungen und Zweckmäßigkeiten der Erfindung ergeben sich aus den im Folgenden in Verbindung mit den Figuren 1 bis 15 beschriebenen Ausführungsbeispielen.

Es zeigen:
Figur 1, eine schematische Schnittdarstellung durch ein Substrat mit einem optoelektronischen Halbleiterkörper gemäß einem Ausführungsbeispiel,
Figur 2, eine schematische Schnittdarstellung einer Vorrichtung während eines Verfahrensschrittes gemäß einem Ausführungsbeispiel,
Figur 3, eine schematische Schnittdarstellung der Vorrichtung gemäß Figur 2 während einem weiteren Verfahrensschritt,
Figuren 4A bis 4D, schematische Schnittdarstellungen einer Vorrichtung in verschiedenen Verfahrensstadien gemäß einem Ausführungsbeispiel,
Figur 4E, eine schematische Schnittdarstellung der Vorrichtung während einer alternativen Ausführung des Verfahrensschrittes gemäß Figur 4B,
Figur 5, eine schematische Schnittdarstellung durch ein optoelektronisches Bauelement gemäß einem Ausführungsbeispiel während einem Verfahrensschritt,
Figur 6, eine schematische Schnittdarstellung durch ein weiteres optoelektronisches Bauelement gemäß einem Ausführungsbeispiel während einem Verfahrensschritt,
Figur 7, eine schematische Schnittdarstellung durch ein weiteres optoelektronisches Bauelement gemäß einem Ausführungsbeispiel während einem Verfahrensschritt,
Figur 8, eine schematische Schnittdarstellung durch zwei optoelektronische Bauelemente gemäß einem weiteren Ausführungsbeispiel während einem Verfahrensschritt,
Figuren 9, 10 und 11, schematische Schnittdarstellungen durch ein optoelektronisches Bauelement während jeweils einem Verfahrensstadium gemäß einem Ausführungsbeispiel,
Figuren 12A bis 12E, schematische Schnittdarstellungen durch ein Dichtelement gemäß jeweils einem Ausführungsbeispiel, und
Figuren 13 bis 15, schematische Schnittdarstellungen durch ein optoelektronisches Bauelement gemäß jeweils einem Ausführungsbeispiel.

In den Ausführungsbeispielen und Figuren sind gleiche oder gleich wirkende Bestandteile jeweils mit den gleichen Bezugszeichen versehen. Die dargestellten Elemente der Figuren sind nicht notwendigerweise als maßstabsgerecht anzusehen. Vielmehr können einzelne Bestandteile zum besseren Verständnis teilweise übertrieben groß dargestellt sein.

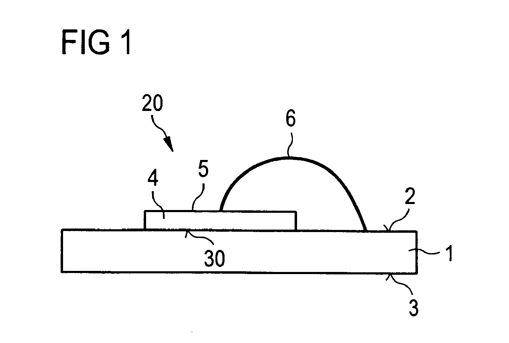

Das Substrat 1 gemäß dem Ausführungsbeispiel der Figur 1 weist eine erste Hauptfläche 2 und eine zweite Hauptfläche 3 auf, wobei auf die erste Hauptfläche 2 ein strahlungserzeugender Halbleiterkörper 4, beispielsweise ein Dünnfilmhalbleiterchip, montiert ist. Der Halbleiterkörpers 4 ist hierbei mit einer Anschlussstelle auf der ersten Hauptfläche des Substrates elektrisch leitend verbunden, vorliegend mittels eines Bonddrahtes 6.

Bei dem Substrat 1 handelt es sich beispielsweise um ein vorgeformtes Gehäuse, einen vorgeformten Leadframe, einen vorgeformten Leadframe mit Wärmesenke oder ein Printed Circuit Board. Das Substrat 1 kann beispielsweise Keramik oder Kupfer aufweisen oder aus einem dieser Materialien bestehen. So kann als Substrat 1 beispielsweise eine Keramik- oder eine Kupferplatte oder ein Schichtverbund dieser Materialien, wie ein DBC-Substrat, verwendet werden.

Weiterhin kann als Substrat 1 auch ein strukturierter metallischer Leadframe verwendet werden, der zur mechanischen Fixierung in dem Werkzeug zumindest einen Durchbruch aufweist. Ein solcher strukturierter Leadframe weist bevorzugt Tape auf der zweiten Hauptfläche 3 auf, um Verunreinigungen mit Kunststoffmaterial zu vermeiden.

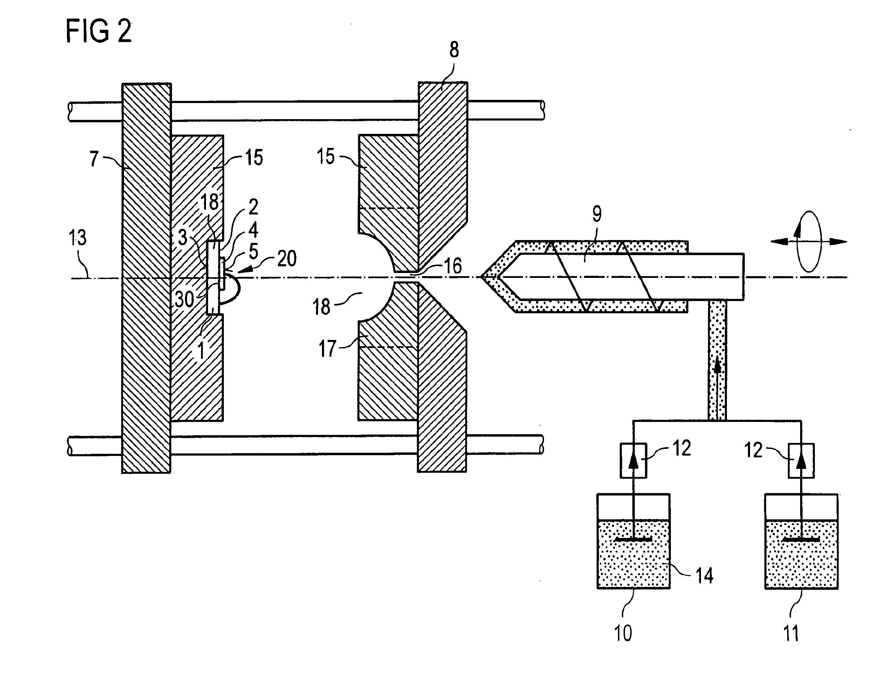

Die Vorrichtung gemäß dem Ausführungsbeispiel der Figur 2 umfasst zwei Aufspannplatten 7, 8 und ein Dosiersystem 9, vorliegend eine Schnecke, sowie zwei Behälter 10, 11 mit jeweils einer Pumpe 12. Die Aufspannplatten 7, 8 sind parallel zueinander angeordnet. Weiterhin sind die Aufspannplatten 7, 8 und die Schnecke 9 auf einer gemeinsamen Achse 13 angeordnet. Die Schnecke 9 kann entlang der Achse 13 bewegt werden sowie um die Achse 13 rotieren (siehe Pfeile in Figur 2). Die beiden Behälter 10, 11 sind dafür vorgesehen, ein Kunststoffmaterial 14 zu umfassen. Dieses Kunststoffmaterial kann jeweils aus dem Behälter mit Hilfe der Pumpe in Richtung Schnecke 9 transportiert werden, wie die Pfeile in Figur 2 andeuten.

Anstelle einer Schnecke kann auch ein Kolbendosierer als Dosiersystem 9 eingesetzt werden.

Auf jeweils eine Aufspannplatte 7, 8 ist bei der Vorrichtung gemäß der Figur 2 ein Teil eines Werkzeuges 15 aufgespannt. Der Teil des Werkzeuges 15, der auf der schneckenseitigen Aufspannplatte aufgespannt ist, weist ein Angusssystem 16 sowie einen Formkern 17 mit einer Kavität 18 auf. Die Kavität 18 ist vorliegend gemäß einer Linse 19 ausgebildet, dass heißt, sie weist die Kontur der Linse 19 auf.

Gegenüber der schneckenseitigen Aufspannplatte 8 ist eine weitere Aufspannplatte 7 angeordnet, auf die ein weiterer Teil des Werkzeuges 15 montiert ist. Dieser Teil des Werkzeuges 15 weist eine weitere Kavität 18 auf, in die das Substrat 1 mit dem elektrisch kontaktierten optoelektronischen Halbleiterkörper 4 gemäß Figur 1 als Einlegeteil 20 eingelegt ist.

Vorliegend sind die erste Hauptfläche 2 und die zweite Hauptfläche 3 des Substrates 1 planparallel zueinander ausgebildet. Weiterhin sind auch die strahlungsemittierende Vorderseite 5 des Halbleiterkörpers 4 und die der Vorderseite gegenüberliegende Rückseite 30 des Halbleiterkörpers 4 planparallel zueinander sowie planparallel zu der ersten Hauptfläche 2 bzw. der zweiten Hauptfläche 3 des Substrates 1 angeordnet. Weiterhin sind auch die beiden Aufspannplatten 7, 8 planparallel zu der ersten Hauptfläche 2 und der zweiten Hauptfläche 3 des Substrates 1 und damit ebenso planparallel zu der Vorderseite 5 und der Rückseite 30 des Halbleiterkörpers 4 ausgebildet.

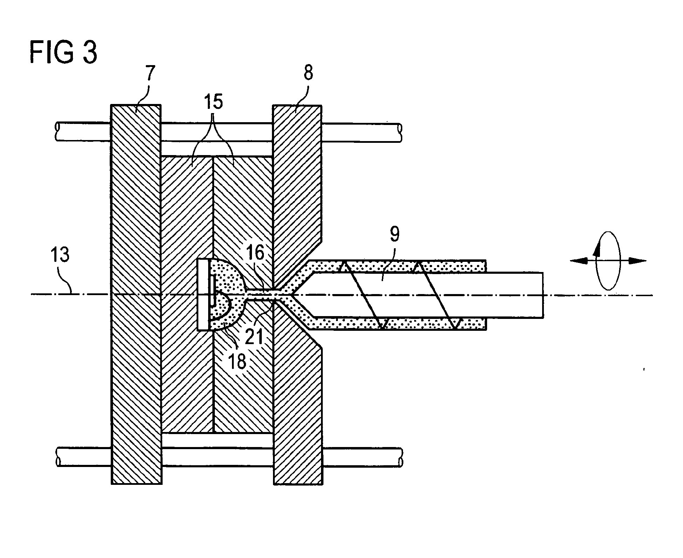

Um mittels einem Kunststoffverarbeitungsprozess eine Umhüllung über der strahlungsemittierenden Vorderseite 5 des Halbleiterkörpers 4 aufzubringen, wobei die Umhüllung als optisches Element 19 ausgebildet ist, wird das Werkzeug 15 derart geschlossen, dass sich die beiden Teile des Werkzeuges einander berühren und seitlich der Kavitäten 18 eine gemeinsame Grenzfläche ausbilden, wie in Figur 3 gezeigt. Im geschlossenen Zustand ist die Kavität 18 des Werkzeuges 15 über dem optoelektronischen Halbleiterkörper 4 angeordnet und bildet dort einen geschlossenen Hohlraum in Form eines optischen Elementes 19, vorliegend einer Linse, aus.

Alternativ ist es auch möglich, dass der Teil des Werkzeuges mit der Kavität 18, die gemäß der Linse 19 geformt ist, derart ausgebildet ist, dass die geschlossene Kavität 18 gemeinsam mit der ersten Hauptfläche 2 des Substrates 1 gebildet wird. In diesem Fall ist es nicht zwingend notwendig, dass sich die beiden Teile des Werkzeuges 15 einander berühren und eine gemeinsame Grenzfläche ausbilden. Vielmehr berührt in diesem Fall der eine Teil des Werkzeuges 15 die erste Hauptfläche 2 des Substrates 1 und bildet mit dieser eine gemeinsame Grenzfläche aus.

Ist das Werkzeug 15 geschlossen, wird die Schnecke 9 entlang der Achse 13 in Richtung des Werkzeuges 15 an einen Anspritzpunkt 21 des Angusssystems 16 gefahren. Durch Rotation der Schnecke 9 wird Kunststoffmaterial 14 durch das Angusssystem 16 in die geschlossene Kavität 18 eingespritzt.

Bei dem Kunststoffverarbeitungsprozess des Ausführungsbeispiels gemäß der Figuren 2 und 3 handelt es sich um Liquid-Injection-Molding-Spritzguss. Dieser Kunststoffverarbeitungsprozess ermöglicht vorteilhafterweise eine massenfertigungstaugliche Formung der Umhüllung, wobei diese gleichzeitig als optisches Element 19 ausgebildet wird, das die Abstrahlcharakteristik des optoelektronischen Bauelementes auf gewünschte Art und Weise formt. Mit Liquid-Injection-Molding-Spritzguss können Taktzeiten zwischen 20 sec und 300 sec erreicht werden.

Als Kunststoffmaterial 14 kann für die Umhüllung beispielsweise ein Silikon oder ein Hybridmaterial, das Silikon und Epoxidharz umfasst, verwendet werden. Das Hybridmaterial kann zwischen 10 % und 70 % Epoxidharz aufweisen, bevorzugt 50 %.

Da Silikone und Hybridmaterialien im ungehärteten Zustand niedrige Viskositäten aufweisen - diese liegen in der Regel zwischen 1 Pas und 100 Pas, wobei die Grenzen eingeschlossen sind - ist ein gutes Abschließen der Kavität 18 wichtig, um Verunreinigungen der Substratoberfläche seitlich der Kavität 18 während des Einspritzvorganges zu vermeiden. Solche Verunreinigungen können insbesondere beim späteren elektrischen Kontaktieren des optoelektronischen Bauelementes störend sein und aufwendige zusätzliche Montageschritte bei der Herstellung des optoelektronischen Bauelementes erfordern.

Um die Kavität 18 besser füllen und damit exakter abformen zu können, kann die Kavität 18 während des Einspritzvorganges evakuiert werden. Hierzu werden in dem Werkzeug Kanäle vorgesehen, die die Kavität mit einer Vakuumpumpe verbinden (in den Figuren nicht dargestellt).

Da das Substrat 1 zwei gegenüberliegende, planparallele Hauptflächen 2, 3 aufweist, aus denen keine weiteren Elemente herausragen, beispielsweise elektrische Anschlussteile, ist das Substrat 1 mit dem Halbleiterkörper 4 besonders gut geeignet, als Einlegeteil in die Kavität 18 eines Werkzeuges 15 eingelegt zu werden, wie es das Ausführungsbeispiel der Figuren 2 und 3 zeigt. Seitlich der beiden Hauptflächen 2, 3 können jedoch sehr wohl Elemente, beispielsweise elektrische Anschlussteile herausragen.

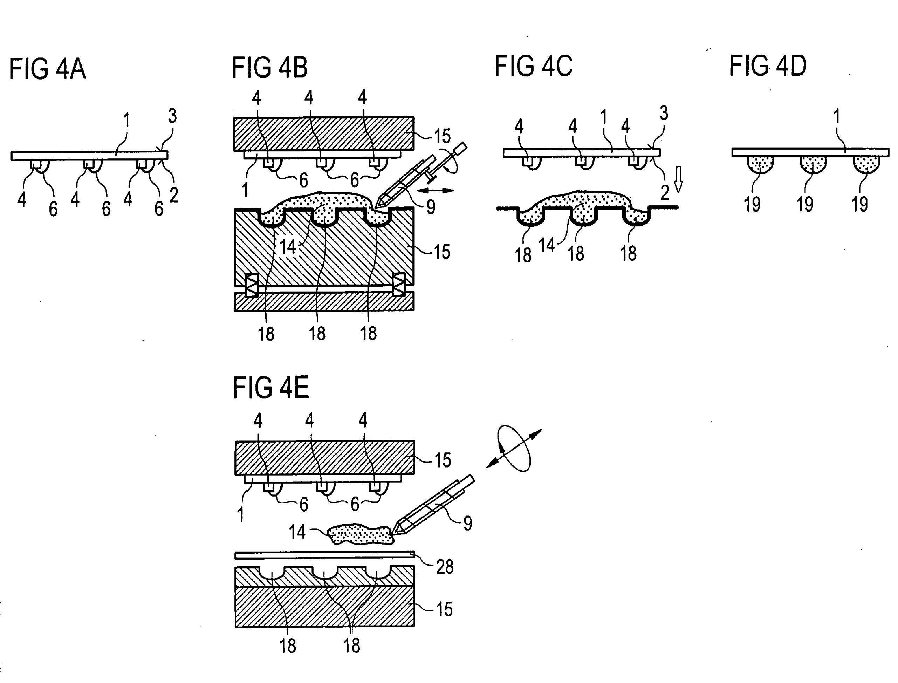

Bei dem Ausführungsbeispiel gemäß der Figuren 4A bis 4D handelt es sich um ein Verfahren, bei dem im Unterschied zu dem Verfahren gemäß den Figuren 2 und 3 Compression Molding Spritzguss als Kunststoffverarbeitungsprozess verwendet wird. Weiterhin zeigen die Figuren 4A bis 4D die parallele Herstellung mehrerer optoelektronischer Halbleiterbauelemente.

Wie in Figur 4A gezeigt, werden auf einer ersten Hauptfläche 2 eines Substrates 1 mehrere Halbleiterkörper 4 angeordnet und jeweils mit einem Bonddraht 6 elektrisch kontaktiert. Dann, wie in Figur 4B gezeigt, wird das Substrat 1 an einem Teil eines Werkzeuges 15 angeordnet, beispielsweise indem es als Einlegeteil in eine Kavität 18 des Werkzeuges 15 eingelegt wird. Gegenüber zu dem einen Teil des Werkzeuges 15 ist parallel ein weiterer Teil des Werkzeuges 15 angeordnet, der passend zu jedem Halbleiterkörper 4 eine Kavität 18 aufweist, die die inverse Form, dass heißt die Kontur, einer Linse 19 aufweist. Seitlich des Werkzeuges 15 ist ein Dosiersystem 9 angeordnet, das geeignet ist, Kunststoffmaterial 14 während eines Einspritzvorganges bei geöffnetem Werkzeug 15 in die Kavitäten 18 zu transportieren. Bei dem Dosiersystem 9 handelt es sich vorliegend um einen statisch-dynamischen Mischer, etwa um einen Dosierer mit Mischstück. Alternativ ist es jedoch auch möglich, eine Schnecke zu verwenden.

Nach dem Einbringen von Kunststoffmaterial 14 in die Kavitäten 18 werden die beiden Werkzeughälften 15 geschlossen, wie in Figur 4C schematisch durch einen Pfeil gezeigt. Beim Schließen des Werkzeuges 15 füllt das Kunststoffmaterial 14 die Kavitäten 18 aus und bildet eine Umhüllung in Form des optischen Elementes 19 über den Vorderseiten der jeweiligen Halbleiterkörper 4 aus, wie in Figur 4D gezeigt.

Wie bei dem Ausführungsbeispiel gemäß der Figuren 1, 2 und 3 kann als Substrat 1 bei dem Ausführungsbeispiel gemäß der Figuren 4A bis 4D ein vorgeformtes Gehäuse, ein vorgeformter Leadframe, ein vorgeformter Leadframe mit einer Wärmesenke, ein DBC-Substrat oder ein Printed Circuit Board verwendet werden. Das Substrat 1 kann beispielsweise Kupfer oder Keramik umfassen oder aus einem dieser Materialien bestehen.

Als Kunststoffmaterial 14 können bei dem Ausführungsbeispiel gemäß der Figuren 4A bis 4D dieselben Materialien verwendet werden, wie bei dem Ausführungsbeispiel gemäß der Figuren 1, 2 und 3.

Wie in Figur 4E gezeigt, kann vor dem Einspritzen des Kunststoffmaterials 14 mit dem Dosiersystem 9 in das geöffnete Werkzeug 15 eine Folie 28 zwischen die Kavitäten 18 und das Substrat 1 eingebracht werden. Vorliegend ist die Folie 28 derart angeordnet, dass sie beim Schließen des Werkzeuges 15 direkt an die Kavitäten 18 angrenzt und so zu einer besseren Abformung der Kavitäten 18 führt. Die Folie 28 verhindert, dass Kunststoffmaterial 14 mit der Werkzeugwand in Berührung kommt und dort unerwünscht haften bleibt. Um die Folie 28 in Richtung der Werkzeugwand zu bringen, kann beispielsweise ein Vakuum eingesetzt werden, dass die Folie 28 in Richtung der Werkzeugwand zieht.

Weiterhin kommt die Folie 28 beim Schließen des Werkzeuges 15 zwischen dem Substrat 1 und dem Teil des Werkzeuges 15 zu liegen, der die Kavität 18 mit der Kontur des optischen Elementes aufweist. Die Folie 28 grenzt hierbei auf der einen Seite direkt an das Substrat 1 an, dass heißt sie bildet eine gemeinsame Grenzfläche mit dem Substrat 1 aus. Auf der anderen Seite grenzt die Folie 28 direkt an das Werkzeug 15 an, dass heißt, sie bildet eine gemeinsame Grenzfläche mit dem Werkzeug 15 aus. Dadurch kann die Folie 28 Unebenheiten des Substrates 1 und auch des Werkzeuges 15 ausgleichen, wodurch zumindest die Menge an Kunststoffmaterial 14 vorteilhafterweise verringert wird, die aus der Kavität 18 auf das Substrat 1 gelangen kann.

Nach dem Ausbilden der Umhüllung wird das Werkzeug 15 wieder geöffnet und die Folie 28 wieder entfernt.

Da das Werkzeug 15 in der Regel beheizt wird, wird bevorzugt eine temperaturbeständige Folie 28 verwendet, die besonders bevorzugt für Temperaturen zwischen 100°C und 150°C beständig ist, wobei die Grenzen eingeschlossen sind.

Die Folie 28 weist bevorzugt eine Dicke zwischen 20 *µ*m und 100 *µ*m auf, wobei die Grenzen eingeschlossen sind. Die Folie 28 kann beispielsweise Ethylen-Tetrafluorethylen (ETFE) aufweisen oder aus diesem Material bestehen.

Alternativ oder zusätzlich zu der Folie 28 kann auch eine Dichtungsschicht 22 auf dem Substrat 1 aufgebracht werden. Bevorzugt wird eine solche Dichtungsschicht 22 in Verbindung mit einem Werkzeug verwendet, dessen Material mit dem Kunststoffmaterial keine Haftung eingeht. Hierzu kann das Werkzeug beispielsweise beschichtet sein.

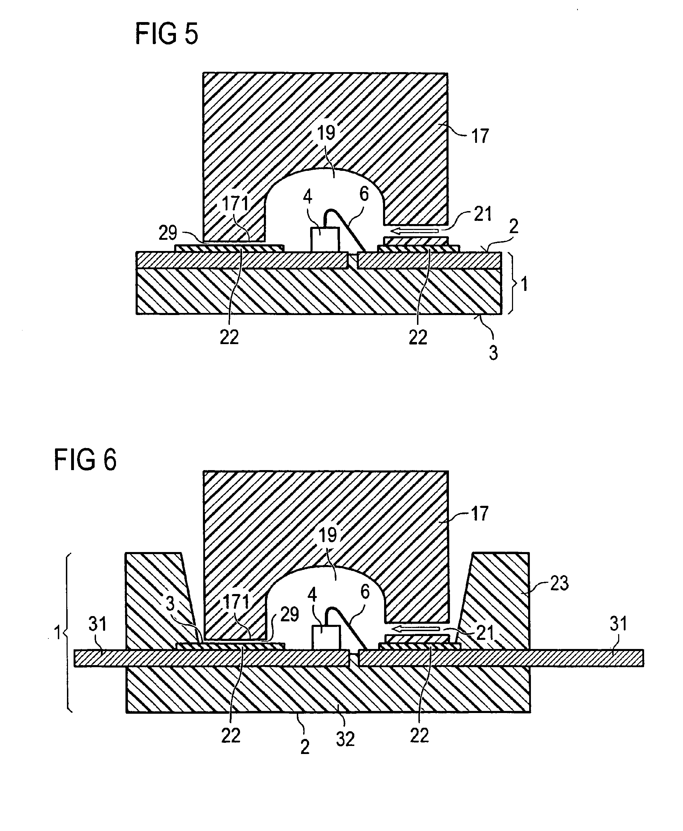

Das optoelektronische Bauelement gemäß dem Ausführungsbeispiel der Figur 5 weist als Substrat 1 einen vorgeformten Leadframe mit einer Wärmesenke auf. Auf die erste Hauptfläche 2 des Substrates 1 ist ein optoelektronischer, zur Strahlungserzeugung geeigneter Halbleiterkörper 4 montiert. Der optoelektronische Halbleiterkörper 4 ist mittels eines Bonddrahtes 6 elektrisch kontaktiert. Seitlich des Halbleiterkörpers 4 ist auf die erste Hauptfläche 2 des Substrates 1 eine Dichtungsschicht 22 aufgebracht, die dazu vorgesehen ist, Unebenheiten des Substrates 1 auszugleichen.

Weiterhin umfasst das optoelektronische Bauelement gemäß dem Ausführungsbeispiel der Figur 5 eine Umhüllung des Halbleiterkörpers über der Vorderseite, die in Form eines optischen Elementes 19, vorliegend einer Linse, ausgeführt ist und durchlässig ist für die elektromagnetische Strahlung des Halbleiterkörpers 4.

Die Umhüllung des Halbleiterkörpers 4 ist mit einem Kunststoffverarbeitungsprozess, vorliegend Liquid-Injection-Molding-Spritzguss, wie beispielsweise anhand der Figuren 1 bis 3 bereits beschrieben, hergestellt.

Die Figur 5 zeigt weiterhin einen Formkern 17 eines Werkzeuges 15, der eine Kavität 18 mit einer Linsenkontur aufweist, wie es oben bereits beschriebenen wurde. Der Formkern 17 weist einen seitlichen Anspritzpunkt 21 auf, durch den Kunststoffmaterial 14 während des Einspritzvorganges in die Kavität 18 eingebracht werden kann. Um Verunreinigungen des Substrates 1 außerhalb der Umhüllung beim Einspritzvorgang zu vermeiden, ist bei dem Ausführungsbeispiel der Figur 5 eine Dichtungsschicht 22 auf die erste Hauptfläche 2 des Substrates 1 aufgebracht. Die Dichtungsschicht 22 ist insbesondere in dem Bereich des Substrates 1 aufgebracht, auf den der Formkern 17 beim Schließen des Werkzeuges 15 aufsetzt. Die Dichtungsschicht 22 hat hierbei die Aufgabe, Unebenheiten des Substrates auszugleichen, wie sie insbesondere bei Keramiksubstraten vorhanden sein können.

Die Dichtungsschicht 22 weist beispielsweise einen Trockenresist auf oder besteht aus diesem Material. Die Dichtungsschicht 22 kann beispielsweise mit Hilfe eines Druckverfahrens, wie Siebdruck, Tampondruck, Inkjetverfahren aufgebracht werden. Weiterhin kann als Dichtungsschicht 22 eine Metallisierung oder eine Folie auf die erste Hauptfläche 2 des Substrates 1 aufgebracht werden. Weiterhin kann die Dichtungsschicht 22 auch strukturiert aufgebracht sein, beispielsweise indem sie Kanäle zur Entlüftung der Kavität beim Einspritzvorgang aufweist. Die Dichtungsschicht 22 und das optische Element 19 haben vorzugsweise eine gemeinsame Grenzfläche.

Weiterhin weist bei dem Ausführungsbeispiel gemäß der Figur 5 eine Oberfläche 171 des Formkerns 17 des Werkzeuges 15 auf der dem Anspritzpunkt 21 gegenüber liegenden Seite gegenüber der Dichtungsschicht 22 eine Ausnehmung auf, so dass die Ausnehmung und die Dichtungsschicht 22 einen Entlüftungskanal 29 ausbilden. Mit anderen Worten ist die Oberfläche 171 des Formkerns 17 derart zurückgesetzt, dass diese zusammen mit der Dichtungsschicht 22 einen Entlüftungskanal 29 ausbildet.

Über den Entlüftungskanal 29 kann während des Einspritzvorganges eine Entlüftung der Kavität 18 stattfinden. Hierdurch ist eine genauere Abformung der Linsenkontur möglich.

Das optoelektronische Bauelement gemäß dem Ausführungsbeispiel der Figur 6 ist bis auf das Substrat 1 gleich zu dem optoelektronischen Bauelement des Ausführungsbeispieles der Figur 5. Bei dem Ausführungsbeispiel der Figur 6 umfasst das Substrat 1 seitlich eine Struktur 23, vorliegend eine Schräge, die beispielsweise umlaufend um den Halbleiterkörper 4 ausgebildet sein kann, die als Zentrierhilfe für den Formkern 17 während des Spitzgießprozesses dient. Hierzu ist die Struktur 23 zweckmäßigerweise derart auf dem Substrat 1 angeordnet, dass sie bei geschlossenem Werkzeug 15 um den Formkern 17 herum läuft. Weiterhin weist das Substrat 1 gemäß dem Ausführungsbeispiel der Figur 6 zwei Anschlussstreifen 31 auf, die seitlich aus einem Gehäusekörper 32 herausragen. Die Anschlussstreifen 31 sind hierbei planparallel zur zweiten Hauptfläche 3 des Substrates 1 ausgebildet. Weiterhin ist auch der Teil der ersten Hauptfläche 2 planparallel zur zweiten Hauptfläche 3 ausgebildet, der innerhalb der Zentrierhilfe liegt und auf dem der Halbleiterkörper 4 sowie die Dichtungsschicht 22 angeordnet ist.

Der Gehäusekörper 32 kann beispielsweise zumindest eines der folgenden Thermoplastkunststoffe aufweisen oder aus zumindest einem der folgenden Thermoplastkunststoffe bestehen: PPA, LPC, PEEK.

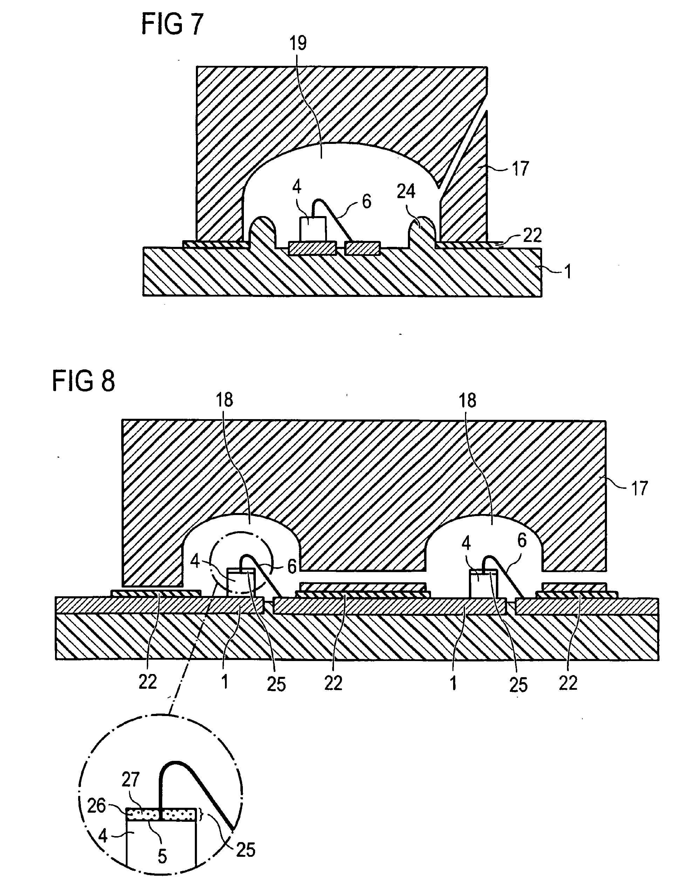

Auch das optoelektronische Bauelement gemäß dem Ausführungsbeispiel der Figur 7 unterscheidet sich von den optoelektronischen Bauelementen gemäß der Figuren 5 und 6 im Wesentlichen durch die Ausführung des Substrates 1. Als Substrat 1 ist vorliegend eine Basisplatte, beispielsweise aus Keramik, mit einer Metallisierung als Dichtungsschicht 22 verwendet. Weiterhin weist die erste Hauptfläche 2 des Substrates 1 angrenzend an die Dichtungsschicht 22 eine umlaufende domartige Erhebung 24 auf, die in die Umhüllung hineinragt und diese besser mit dem Substrat 1 verankert. Die Verankerung kann beispielsweise durch eine Erhöhung der Kontaktfläche zwischen Umhüllung und Substrat aufgrund der domartigen Erhebung 24 verursacht werden oder durch eine Hinterschneidung der domartigen Erhebung 24 nach außen oder innen. Alternativ zu einer umlaufenden domartigen Erhebung 24, kann auch eine einzelne oder mehrere separate domartige Erhebungen auf der ersten Hauptfläche 2 des Substrates 1 verwendet sein.

Figur 8 zeigt ein Ausführungsbeispiel eines Verfahrens bei dem in einem Rolle-zu-Rolle-Prozess mehrere zusammenhängende Substrate 1 gleichzeitig - vorliegend sind beispielhaft zwei Substrate 1 gezeigt - verarbeitet werden. Als Substrat 1 können beispielsweise Leadframes verwendet werden, die auf einer Rolle aufgebracht sind. Jeweils auf eine erste Hauptfläche 2 der Substrate 1 ist jeweils ein optoelektronischer Halbleiterkörper 4 aufgebracht, der mit einem Bonddraht 6 elektrisch leitend kontaktiert ist. Seitlich der Halbleiterkörper 4 weist das Substrat 1 auf seiner ersten Hauptfläche 2 eine Dichtungsschicht 22 auf, wie sie bereits anhand der Figuren 5 bis 7 beschrieben wurde. Die Dichtungsschicht 22 ist hierbei auf den Teilen der ersten Hauptfläche 2 angeordnet, die planparallel zur zweiten Hauptfläche 3 verlaufen. Zum Schutz des optoelektronischen Halbleiterkörpers 4 kann optional ein Platzhalter über dem Halbleiterkörper angeordnet sein, der aus Gründen der Übersichtlichkeit in der Figur 8 nicht dargestellt ist. Über dem Substrat 1 zeigt die Figur 8 weiterhin einen Formkern 17 mit zwei Kavitäten 18, die eine Linsenkontur aufweisen und über den Halbleiterkörpern 4 angeordnet sind. Die Kavitäten 18 sind untereinander mit Kanälen verbunden, durch die das Kunststoffmaterial 14 hindurch dringen kann. Weiterhin ist der Formkern 17 seitlich zurückgesetzt, um eine Entlüftung der Kavitäten 18 zu erlauben.

Auf der strahlungsemittierenden Vorderseite 5 der optoelektronischen Halbleiterkörper 4 bei dem Ausführungsbeispiel gemäß der Figur 8 ist weiterhin jeweils eine wellenlängenkonvertierende Schicht 25 aufgebracht. Vorliegend umfasst die wellenlängenkonvertierende Schicht 25 Partikel eines Wellenlängenkonversionsstoffes 26, der in ein Bindemittel 27 eingebettet ist. Als Wellenlängenkonversionsstoff 26 kann beispielsweise eines der im allgemeinen Beschreibungsteil bereits angegeben Materialien verwendet werden. Ebenso sind als Bindemittel 27 eines der bereits im allgemeinen Beschreibungsteil angegeben Materialien geeignet.

Um gleichzeitig mehrere optoelektronische Bauelemente herzustellen, ist es weiterhin möglich, mehrere optoelektronische Halbleiterkörper 4 auf einem Substrat 1 oder auf mehrere zusammenhängende Substrate 1 aufzubringen und dann jeweils eine Umhüllung über der Vorderseite des Halbleiterkörpers 4 aufzubringen, wobei die Umhüllung als optisches Element 19 unter Verwendung einer geschlossenen Kavität 18 ausgebildet wird, die die Kontur des optischen Elementes 19 aufweist. Hierzu kann beispielsweise ein Kunststoffverarbeitungsprozess, wie LIM-Spritzguss oder Compression Molding, wie oben bereits beschrieben, eingesetzt werden. Im Unterschied zu den oben beschriebenen Ausführungsbeispielen wird jedoch ein Werkzeug 15 verwendet, das mehrere Kavitäten 18 mit der Kontur des optischen Elementes 19 aufweist. Nach dem Aufbringen der Umhüllung werden die einzelnen optoelektronischen Bauteile vereinzelt, beispielsweise durch Sägen.

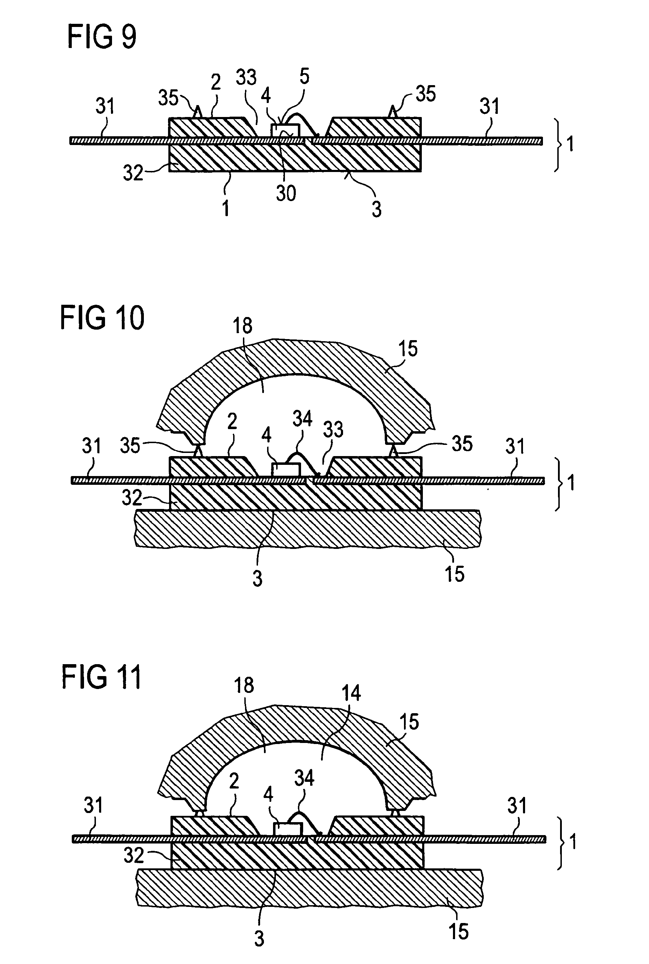

Bei dem Verfahren gemäß dem Ausführungsbeispiel der Figuren 9, 10 und 11 ist das Substrat 1 als ein vorgeformtes Gehäuse ausgebildet. Das vorgeformte Gehäuse umfasst einen Gehäusekörper 32, der Kunststoff aufweist, sowie zwei elektrische Anschlussstreifen 31, die Teil eines Leadframes sind. Der Gehäusekörper 32 weist eine erste Hauptfläche 2 und eine zweite Hauptfläche 3 auf, wobei die zweite Hauptfläche 3 der ersten Hauptfläche 2 gegenüberliegt. Weiterhin weist der Gehäusekörper 32 in seiner ersten Hauptfläche 2 eine Ausnehmung 33 auf, in die der Halbleiterkörper 4 montiert ist. Die Bereiche der ersten Hauptfläche 2, die seitlich der Ausnehmung 33 angeordnet sind, sind hierbei planparallel zur zweiten Hauptfläche 3 ausgebildet. Weiterhin sind auch die elektrischen Anschlussstreifen 31 planparallel zur zweiten Hauptfläche 3 ausgebildet.

Die beiden Anschlussstreifen 31 sind derart in den Gehäusekörper 32 eingebracht, dass jeweils ein Teil der Oberfläche jedes Anschlussstreifens 32 einen Teil der Oberfläche der Ausnehmung 33 ausbildet.

Der Halbleiterkörper 4 ist derart in der Ausnehmung 33 montiert, dass eine elektrisch leitende Verbindung zwischen seiner Rückseite 30 und dem einen Anschlussstreifen 31 besteht. Dies kann beispielsweise mit Hilfe eines elektrisch leitenden Klebstoffes erreicht werden. Mit dem anderen Anschlussstreifen 31 ist der Halbleiterkörper 4 über einen Bonddraht 34 auf seiner Vorderseite 5 elektrisch leitend verbunden.

Weiterhin ist auf den Bereichen der ersten Hauptfläche 2 des Gehäusekörpers 32, der planparallel zur zweiten Hauptfläche 3 ausgebildet ist, ein Dichtelement 35 aufgebracht. Das Dichtelement 35 ist vorliegend derart vollständig umlaufend um die Ausnehmung 33 angeordnet, dass das Dichtelement 35 einen geschlossenen Ring um die Ausnehmung 33 ausbildet. Weiterhin weist das Dichtelement 35 bei dem Ausführungsbeispiel gemäß der Figuren 9, 10 und 11 ein elastisches Material und eine Querschnittsfläche auf, die nach Art eines Dreiecks ausgebildet ist.

Wie in Figur 10 gezeigt, wird das Gehäuse 1 mit dem in die Ausnehmung 33 montierten Halbleiterkörper 4 in einen Teil eines Werkzeuges 15 eingelegt. Ein weiterer Teil des Werkzeuges 15 weist die Kavität 18 mit der Kontur des optischen Elementes 19 auf, gemäß dem die Umhüllung ausgebildet werden soll. Beim Schließen des Werkzeuges 15 setzt der Teil des Werkzeuges 15 mit der Kontur des optischen Elementes 19 derart auf dem zur zweiten Hauptfläche 3 planparallelen Teil der ersten Hauptfläche 2 des Substrates 2 auf, das die Kontur des optischen Elementes 19 eine geschlossene Kavität 18 über dem Halbleiterkörper 4 ausbildet. Das Dichtelement 35 und die Kavität 18 des Werkzeuges 15, das die Kontur des optischen Elementes 19 aufweist, sind hierbei derart zueinander angeordnet, dass die Kontur des zu fertigenden optischen Elementes 19 mit dem Dichtelement 35 seitlich abschließt.

In einem weiteren Verfahrensschritt, der schematisch in Figur 11 dargestellt ist, wird nun ein Schließdruck auf das Werkzeug 15 aufgebracht, so dass das Dichtelement 35 verformt und die Kavität 18 seitlich abgedichtet wird. Mit Hilfe einer gesteuerten Flächenpressung kann hierbei der Schließdruck in der Regel verringert werden, so dass verringerte Kräfte auf das Bauteil wirken. Es kann nun die Kavität 18 mit dem Kunststoffmaterial 14, beispielsweise einem Silikon, gefüllt werden. Das Dichtelement 35 vermindert hierbei zumindest die Menge an Kunststoffmaterial 14, die auf die erste Hauptfläche 2 des Substrates 1 gelangt.

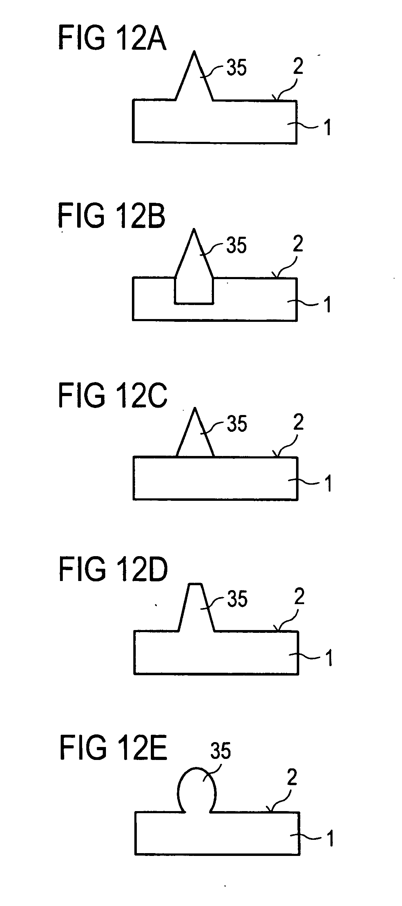

Die Dichtelemente 35 gemäß den Ausführungsbeispielen der Figuren 12A bis 12E sind auf die erste Hauptfläche 2 des Substrates 1 aufgebracht, wobei die Dichtelemente 35 gemäß den Ausführungsbeispielen der Figuren 12A bis 12C einen Querschnitt aufweisen, der nach Art eines Dreiecks ausgebildet ist.

Das Dichtelement 35 gemäß dem Ausführungsbeispiel der Figur 12A weist das gleiche Material auf, wie das Substrat 1 und ist in das Substrat 1 integriert. Das Dichtelement 35 ist vorliegend gemeinsam mit dem Substrat 1 gefertigt, beispielsweise mit einem Spritzgussverfahren.

Das Dichtelement 35 gemäß dem Ausführungsbeispiel der Figur 12B weist ein Material auf, das von dem Material des Substrates 1 verschieden ist. Weiterhin ist das Dichtelement 35 in das Substrat 1 eingearbeitet. Ist das Substrat 1 mit einem Spritzgussverfahren gefertigt, so können das Substrat 1 und das Dichtelement 35 beispielsweise mit einem mehrkomponentigen Spritzgussverfahren gefertigt sein. Alternativ ist es auch möglich, dass das Substrat 1 eine Nut aufweist, in die ein separat gefertigtes Dichtelement 35 eingefügt wird.

Das Dichtelement 35 gemäß dem Ausführungsbeispiel der Figur 12C weist, wie das Dichtelement 35 gemäß dem Ausführungsbeispiel der Figur 12B ein Material auf, das von dem Material des Substrates 1 verschieden ist. Das Dichtelement 35 ist vorliegend auf die erste Hauptseite 2 des Substrates 1 aufgebracht, beispielsweise durch Kleben oder Drucken.

Das Dichtelement 35 gemäß dem Ausführungsbeispiel der Figur 12D ist im Unterschied zu den Dichtelementen 35 gemäß den Ausführungsbeispielen der Figuren 12A bis 12C als ein umlaufender Ring mit trapezförmigen Querschnitt ausgebildet. Es ist wie das Dichtelement 35 gemäß dem Ausführungsbeispiel der Figur 12A in das Substrat 1 integriert, beispielsweise mittels Spritzguss.

Das Dichtelement 35 gemäß dem Ausführungsbeispiel der Figur 12E weist im Unterschied zu den Dichtelementen 35 gemäß den Ausführungsbeispielen der Figuren 12A bis 12C einen Querschnitt auf, der teilweise nach Art einer Ellipse ausgebildet ist. Es ist wie die Dichtelemente 35 gemäß den Ausführungsbeispielen der Figur 12A und 12D in das Substrat 1 integriert, beispielsweise mittels Spritzguss.

Die Dichtelemente 35 gemäß den Ausführungsbeispielen der Figuren 12A bis 12E weisen bevorzugt eine Höhe zwischen 0,05 mm und 0,5 mm auf, wobei die Grenzen eingeschlossen sind.

Das Dichtelement 35 ist beispielsweise aus dem gleichen Material gefertigt, wie der Gehäusekörper 32. Das Dichtelement 35 besteht beispielsweise aus einem der folgenden Thermoplastkunststoffe oder weist zumindest einen der folgenden Thermoplastkunststoffe auf: PPA, LCP, PEEK. Weiterhin kann das Dichtelement 35 aus einem elastischen oder verformbaren Material gefertigt sein, während das Substrat aus einem starren Material gefertigt ist. Das Substrat, beispielsweise der Gehäusekörper 32 weist hierbei beispielsweise einen der oben beschriebenen Thermoplastkunststoffe auf, während das Dichtelement 35 beispielsweise ein Silikonmaterial, einen elastomerischen Kunststoff oder einen Lack, wie einen Lötstopplack aufweist.

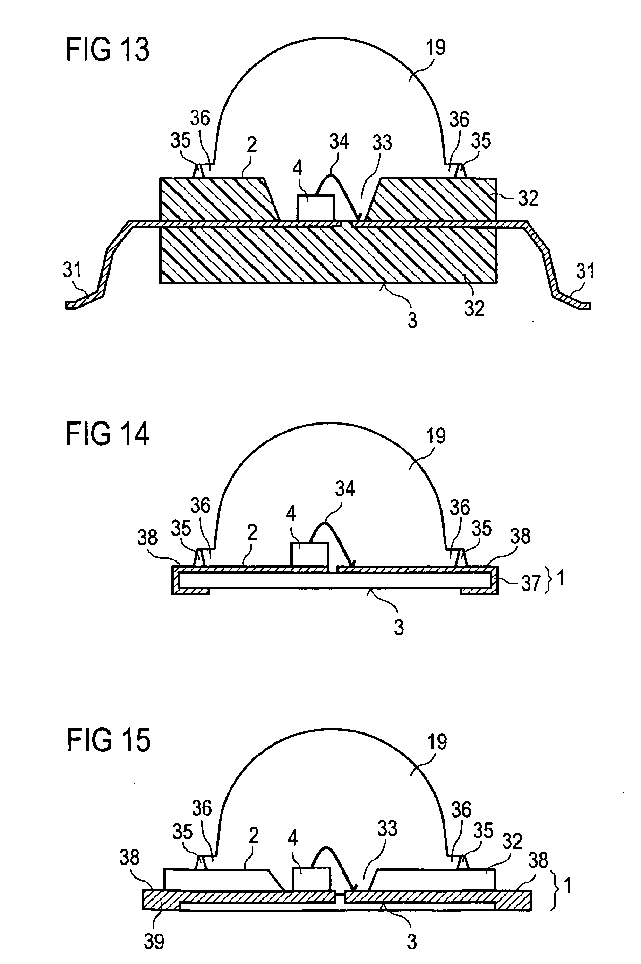

Das optoelektronische Bauelement gemäß dem Ausführungsbeispiel der Figur 13 ist beispielsweise mit den Schritten des Verfahrens gefertigt, wie es anhand der Figuren 9 bis 11 bereits beschrieben wurde. Es weist daher die Merkmale des optoelektronischen Bauelementes auf, die anhand der Figuren 9 bis 11 bereits beschrieben wurden.

Die elektrischen Anschlussstreifen 31 des Bauelementes gemäß dem Ausführungsbeispiel der Figur 13 sind in Richtung der zweiten Hauptfläche 3 des Substrates 1 gebogen.

Das optische Element 19 bei dem optoelektronischen Bauelement gemäß der Figur 13 weist Silikonmaterial auf und ist als Linse 19 ausgebildet. Die Linse 19 weist einen Linsenfuß 36 auf, der seitlich mit dem Dichtelement 35 abschließt. Das Dichtelement 35 weist vorliegend eine trapezförmige Querschnittsfläche auf, wie bereits anhand der Figur 12D beschrieben. Durch das seitliche Abschließen des Linsenfußes 36 mit dem Dichtelement 35, das vorliegend aus einem Licht absorbierenden Material gefertigt ist, ist es vorteilhafterweise möglich, unerwünschtes, seitlich aus dem Linsenfuß 36 austretendes Streulicht zu verringern. Das Dichtelement 35 weist beispielsweise eines der folgenden Materialien auf oder besteht aus einem der folgenden Materialien: PPA, LCP, eingefärbte Elastomere, eingefärbte Silikone.

Das optoelektronische Bauelement gemäß dem Ausführungsbeispiel der Figur 14 weist im Unterschied zu dem optoelektronischen Bauelement gemäß dem Ausführungsbeispiel der Figur 13 eine Leiterplatte als Substrat 1 auf. Als Leiterplatte kann beispielsweise eine Metallkernplatine verwendet sein. Weiterhin kann die Leiterplatte eine Keramik oder ein glasfaserverstärktes Epoxidharz aufweisen. Die Leiterplatte kann beispielsweise eines der folgenden in der Elektronikindustrie üblichen Materialien aufweisen: FR4, FR5, BT.

Die Leiterplatte weist auf ihrer ersten Hauptfläche 2 eine Metallisierung 37 auf, die weiterhin auf den Seitenflächen der Leiterplatte 1 und teilweise auf der zweiten Hauptfläche 3 der Leiterplatte ausgebildet ist.

Der Halbleiterkörper 4 ist auf die Metallisierung 37 auf der ersten Hauptfläche 2 der Leiterplatte 1 derart montiert, dass eine elektrisch leitende Verbindung zwischen der Rückseite 30 des Halbleiterkörpers 4 und der Metallisierung 37 ausgebildet ist. Die Vorderseite 5 des Halbleiterkörpers 4 ist mit einem weiteren Teil der Metallisierung 37 elektrisch leitend verbunden, wobei die Metallisierung 37 derart strukturiert ist, dass ein Kurzschluss vermieden wird.

Das Dichtelement 35 ist vorliegend in direktem Kontakt auf die Metallisierung 37 der Leiterplatte 1 umlaufend um den Halbleiterkörper 34 aufgebracht. Das Dichtelement 35 kann beispielsweise auf die Metallisierung 37 aufgedruckt oder aufgeklebt sein. Weiterhin bildet die Metallisierung 37 seitlich des Dichtelementes 35 jeweils eine externe Anschlussstelle 38 aus, die dazu vorgesehen ist, das optoelektronische Bauelement extern elektrisch zu kontaktieren.

Die übrigen Elemente und Merkmale des optoelektronischen Bauelementes gemäß dem Ausführungsbeispiel der Figur 14, insbesondere die Linse 19 und der Linsenfuß 36, können beispielsweise entsprechend dem Ausführungsbeispiel der Figur 13 ausgebildet sein. Sie werden daher, um Wiederholung zu vermeiden, nicht im Detail ausgeführt.

Auch das optoelektronische Bauelement gemäß dem Ausführungsbeispiel der Figur 15 unterscheidet sich von dem optoelektronischen Bauelement gemäß der Figuren 13 im Wesentlichen durch das Substrat 1. Die übrigen Elemente und Merkmale des optoelektronischen Bauelementes gemäß der Figur 15 können beispielsweise wie anhand der Figur 13 bzw. der Figuren 9 bis 11 bereits beschrieben, ausgeführt sein.

Das Substrat 1 des optoelektronischen Bauelementes gemäß der Figur 15 umfasst, wie das optoelektronische Bauelement gemäß dem Ausführungsbeispiel der Figur 13, einen vorgeformten Gehäusekörper 32, in dem ein elektrisch leitender Streifen 39 verläuft, der zumindest teilweise die Oberfläche der Ausnehmung 33 des Gehäusekörpers 32 ausbildet, in die der Halbleiterkörper 4 montiert ist. Im Unterschied zu dem Substrat 1 gemäß dem Ausführungsbeispiel der Figur 13, bildet der elektrisch leitende Streifen 39 jedoch nicht seitlich des Gehäusekörpers 32 zwei Anschlussstreifen aus. Vielmehr ist der elektrisch leitende Streifen seitlich des Gehäusekörpers 32 jeweils als externe Anschlussstelle 38, beispielsweise als Lötkontakt, ausgebildet, die vorliegend eine zu der zweiten Hauptfläche 3 des Gehäusekörpers 32 planparallele Fläche aufweist.

Die übrigen Elemente und Merkmale des optoelektronischen Bauelementes gemäß dem Ausführungsbeispiel der Figur 15, insbesondere die Linse 19 und der Linsenfuß 36 sowie das Dichtelement 35, können beispielsweise ebenfalls entsprechend dem Ausführungsbeispiel der Figur 13 ausgebildet sein. Sie werden daher, um Wiederholung zu vermeiden, nicht im Detail ausgeführt.

Die Erfindung ist nicht durch die Beschreibung anhand der Ausführungsbeispiele beschränkt.

## Patentansprüche

1. Verfahren zur Herstellung eines optoelektronischen Bauelementes mit den Schritten:
- Bereitstellen eines Substrates (1) mit einer ersten Hauptfläche (2) und einer zweiten Hauptfläche (3), die der ersten Hauptfläche (1) gegenüberliegt,
- Befestigen eines Halbleiterkörpers (4), der geeignet ist, elektromagnetische Strahlung von einer Vorderseite (5) zu emittieren, auf der ersten Hauptfläche (2) des Substrates (1), und
- Aufbringen einer Umhüllung, die durchlässig ist für Strahlung des optoelektronischen Halbleiterkörpers (4), zumindest über der Vorderseite (5) des Halbleiterkörpers (4), bei dem die Umhüllung als optisches Element (19) ausgebildet wird unter Verwendung eines Werkzeuges (15) mit einer geschlossenen Kavität (18), die die Kontur des optischen Elementes (19) aufweist,
- wobei das Substrat (1) auf seiner ersten Hauptfläche (2) zumindest ein Dichtelement (35) aufweist, das umlaufend um den Bereich der ersten Hauptfläche (2) ausgebildet ist, auf den das optische Element (19) aufgebracht wird und das mit dem optischen Element (19) seitlich abschließt, und wobei das Dichtelement (35) einen Querschnitt aufweist, der zumindest teilweise dreieckig, trapezförmig oder nach Art einer Ellipse ausgebildet ist.

2. Verfahren nach Anspruch 1, bei dem
die Umhüllung mittels eines Kunststoffverarbeitungsprozesses aufgebracht wird, wobei als Kunststoffverarbeitungsprozess Liquid-Injection-Molding-Spritzguss (LIM-Spritzguss), Liquid Transfer Molding oder Compression-Molding verwendet wird.

3. Verfahren nach dem vorherigen Anspruch, bei dem eine Folie (28) in das Werkzeug (15) eingelegt wird.

4. Verfahren nach einem der vorhergehenden Ansprüche, bei dem als Umhüllung ein Silikon oder ein Hybridmaterial als Kunststoffmaterial (14) verwendet wird.

5. Verfahren nach einem der vorhergehenden Ansprüche, bei dem als Substrat (1) ein vorgeformtes Gehäuse, ein vorgeformter Leadframe, ein vorgeformter Leadframe mit Wärmesenke oder ein Printed Circuit Board verwendet wird.

6. Verfahren nach einem der vorhergehenden Ansprüche, bei dem auf die erste Hauptfläche (2) des Substrates (1) eine Dichtungsschicht (22) aufgebracht wird.

7. Verfahren nach einem der vorhergehenden Ansprüche, bei dem ein Formkern (17) des Werkzeuges (15) einen Entlüftungskanal (29) aufweist und/oder eine Oberfläche (171) eines Formkernes (17) des Werkzeuges (15) derart zurückgesetzt ist, dass diese zusammen mit einer Oberfläche des Substrates (1) oder der Dichtungsschicht (22) einen Entlüftungskanal (29) ausbildet.

8. Verfahren nach einem der vorhergehenden Ansprüche, bei dem die Kavität (18) vor einem Einspritzvorgang evakuiert wird.

9. Verfahren nach einem der vorhergehenden Ansprüche, bei dem
- mehrere Halbleiterkörper (4), die geeignet sind, elektromagnetische Strahlung zu erzeugen, auf der ersten Hauptfläche (2) des Substrates (1) aufgebracht werden,
- eine Umhüllung, die durchlässig ist für Strahlung des optoelektronischen Halbleiterkörpers (4), zumindest über der Vorderseite (5) der Halbleiterkörper (4) aufgebracht wird, bei dem die Umhüllung als optisches Element (19) ausgebildet wird unter Verwendung einer geschlossenen Kavität (18), die die Kontur des optischen Elementes (19) aufweist, und
- das Substrat (1) nach dem Aufbringen der Umhüllung in separate Bauteile vereinzelt wird.

10. Verfahren nach einem der vorhergehenden Ansprüche, bei dem das Substrat (1) auf seiner ersten Hauptfläche (22) mindestens eine vorzugsweise domartige Erhebung (24) aufweist.

11. Verfahren nach einem der vorhergehenden Ansprüche, bei dem das Substrat (1) auf seiner ersten Hauptfläche (22) eine Struktur (23) als Zentrierhilfe für den Formkern (17) aufweist.

12. Verfahren nach einem der Ansprüche 1 bis 11, bei dem das Dichtelement (35) ein elastisches Material aufweist.

13. Optoelektronisches Bauelement mit:
- einem Substrat (1) mit einer ersten Hauptfläche (2) und einer zweiten Hauptfläche (3), die der ersten Hauptfläche (1) gegenüberliegt,
- einem Halbleiterkörper (4), der geeignet ist, elektromagnetische Strahlung von einer Vorderseite (15) auszusenden, auf der ersten Hauptfläche (2) des Substrates (1),
- einer Umhüllung über der Vorderseite (15) des Halbleiterkörpers (4), die als optisches Element (19) ausgebildet ist und in das optische Bauelement integriert ist,
- wobei das Substrat (1) auf seiner ersten Hauptfläche (2) zumindest ein Dichtelement (35) aufweist, das umlaufend um den Bereich der ersten Hauptfläche (2) ausgebildet ist, auf den das optische Element (19) aufgebracht wird und das mit dem optischen Element (19) seitlich abschließt, **dadurch gekennzeichnet, dass** das Dichtelement (35) einen Querschnitt aufweist, der zumindest teilweise dreieckig, trapezförmig oder nach Art einer Ellipse ausgebildet ist.

## Claims

1. Method for producing an optoelectronic component comprising the following steps:
- providing a substrate (1) having a first main face (2) and a second main face (3), which is situated opposite the first main face (1),
- fixing a semiconductor body (4), suitable for emitting electromagnetic radiation from a front side (5), on the first main face (2) of the substrate (1), and
- applying an encapsulation, which is transmissive to radiation of the optoelectronic semiconductor body (4), at least above the front side (5) of the semiconductor body (4) wherein the encapsulation is embodied as an optical element (19), using a mould (15) having a closed cavity (18) having the contour of the optical element (19),
- wherein the substrate (1) has on its first main face (2) at least one sealing element (35) which is formed circumferentially around that region of the first main face (2) to which the optical element (19) is applied, and which terminates laterally with the optical element (19), and wherein the sealing element (35) has a cross section embodied at least partly in a triangular fashion, in a trapezoidal fashion or in the manner of an ellipse.

2. Method according to claim 1, wherein
the encapsulation is applied by means of a plastic processing process, wherein liquid injection moulding (LIM), liquid transfer moulding or compression moulding is used as the plastic processing process.

3. Method according to the preceding claim, wherein a film (28) is inserted into the mould (15).

4. Method according to any of the preceding claims, wherein a silicone or a hybrid material as plastic material (14) is used as the encapsulation.

5. Method according to any of the preceding claims, wherein a premoulded housing, a premoulded leadframe, a premoulded leadframe with a heat sink or a printed circuit board is used as the substrate (1).

6. Method according to any of the preceding claims, wherein a sealing layer (22) is applied to the first main face (2) of the substrate (1).

7. Method according to any of the preceding claims, wherein a mould core (17) of the mould (15) has a ventilation duct (29) and/or a surface (171) of a mould core (17) of the mould (15) is set back in such a way that said surface together with a surface of the substrate (1) or the sealing layer (22) forms a ventilation duct (29).

8. Method according to any of the preceding claims, wherein the cavity (18) is evacuated before an injection process.

9. Method according to any of the preceding claims, wherein
- a plurality of semiconductor bodies (4) suitable for generating electromagnetic radiation are applied on the first main face (2) of the substrate (1),
- an encapsulation transmissive to radiation of the optoelectronic semiconductor body (4) is applied at least above the front side (5) of the semiconductor bodies (4),
wherein the encapsulation is embodied as an optical element (19), using a closed cavity (18) having the contour of the optical element (19), and
- the substrate (1) is singulated into separate components after the encapsulation has been applied.

10. Method according to any of the preceding claims, wherein the substrate (1) has at least one preferably dome-like elevation (24) on its first main face (22).

11. Method according to any of the preceding claims, wherein the substrate (1) has on its first main face (22) a structure (23) as a centring aid for the mould core (17).

12. Method according to any of claims 1 to 11, wherein the sealing element (35) comprises an elastic material.

13. Optoelectronic component comprising:
- a substrate (1) having a first main face (2) and a second main face (3), which is situated opposite the first main face (1),
- a semiconductor body (4), suitable for emitting electromagnetic radiation from a front side (15), on the first main face (2) of the substrate (1),
- an encapsulation above the front side (15) of the semiconductor body (4), said encapsulation being embodied as an optical element (19) and being integrated into the optical component,
- wherein the substrate (1) has on its first main face (2) at least one sealing element (35) which is formed circumferentially around that region of the first main face (2) to which the optical element (19) is applied, and which terminates laterally with the optical element (19), **characterized in that** the sealing element (35) has a cross section embodied at least partly in a triangular fashion, in a trapezoidal fashion or in the manner of an ellipse.

## Revendications

1. Procédé de fabrication d'un composant optoélectronique, comprenant les étapes consistant à :
- fournir un substrat (1) ayant une première surface principale (2) et une seconde surface principale (3) qui est tournée vers la première surface principale (1),
- fixer un corps semi-conducteur (4) conçu pour émettre un rayonnement électromagnétique par une face avant (5), à la première surface principale (2) du substrat (1), et
- appliquer une enveloppe qui est transparente au rayonnement du corps semi-conducteur optoélectronique (4) sur au moins la face avant (5) du corps semi-conducteur (4), l'enveloppe étant réalisée sous la forme d'un élément optique (19) par utilisation d'un outil (15) comportant une cavité fermée (18) qui présente le contour de l'élément optique (19),
- dans lequel le substrat (1) comprend sur sa première surface principale (2) au moins un élément d'étanchéité (35) qui est réalisé de manière à entourer la région de la première surface principale (2), sur lequel est appliqué l'élément optique (19) et qui assure l'étanchéité latérale avec l'élément optique (19), et dans lequel l'élément d'étanchéité (35) présente une section transversale qui est réalisée de manière au moins partiellement triangulaire, trapézoïdale ou présente la forme d'une ellipse.

2. Procédé selon la revendication 1, dans lequel l'enveloppe est appliquée au moyen d'un processus de transformation de matière plastique, dans lequel on utilise en tant que processus de transformation de matière plastique le moulage par injection de liquide (injection LIM), le moulage par transfert de liquide ou le moulage par compression.

3. Procédé selon les revendications précédentes, dans lequel une feuille (28) est insérée dans l'outil (15).

4. Procédé selon l'une quelconque des revendications précédentes, dans lequel on utilise en tant qu'enveloppe une silicone ou un matériau hybride en tant que matière plastique (14).

5. Procédé selon l'une quelconque des revendications précédentes, dans lequel on utilise en tant que substrat (1) un boîtier préformé, une grille de connexion préformée, une grille de connexion préformée comportant des dissipateurs thermiques ou une carte de circuit imprimé.

6. Procédé selon l'une quelconque des revendications précédentes, dans lequel une couche d'étanchéité (22) est appliquée sur la première surface principale (2) du substrat (1).

7. Procédé selon l'une quelconque des revendications précédentes, dans lequel un noyau de moulage (17) de l'outil (15) comprend un canal de ventilation (29) et/ou dans lequel une surface (171) d'un noyau de moulage (17) de l'outil (15) est supportée de manière à ce qu'elle forme un canal de ventilation (29) avec une surface du substrat (1) ou avec la couche d'étanchéité (22).

8. Procédé selon l'une quelconque des revendications précédentes, dans lequel la cavité (18) est mise sous vide avant le processus d'injection.

9. Procédé selon l'une quelconque des revendications précédentes, dans lequel
- une pluralité de corps semi-conducteurs (4), qui sont aptes à générer un rayonnement électromagnétique, sont appliqués à la première surface principale (2) du substrat (1),
- une enveloppe qui est transparente au rayonnement du corps semi-conducteur optoélectronique (4) est appliquée sur au moins la face avant (5) du corps semiconducteur (4), l'enveloppe étant réalisée sous la forme d'un élément optique (19) par utilisation d'une cavité fermée (18) qui présente le contour de l'élément optique (19), et
- le substrat (1) est découpé en des composants séparés après l'application de l'enveloppe.

10. Procédé selon l'une quelconque des revendications précédentes, dans lequel le substrat (1) comprend sur sa première surface principale (22) au moins une protubérance (24) ayant de préférence la forme d'un dôme.

11. Procédé selon l'une quelconque des revendications précédentes, dans lequel le substrat (1) présente sur sa première surface principale (22) une structure (23) en tant qu'élément d'assistance au centrage du noyau de moulage (17).

12. Procédé selon l'une quelconque des revendications 1 à 11, dans lequel l'élément d'étanchéité (35) comprend un matériau élastique.

13. Composant optoélectronique comportant :
- un substrat (1) ayant une première surface principale (2) et une seconde surface principale (3) qui est tournée vers la première surface principale (1),
- un corps semi-conducteur (4) qui est conçu pour émettre un rayonnement électromagnétique par une face avant (15) sur la première surface principale (2) du substrat (1),
- une enveloppe sur la face avant (15) du corps semi-conducteur (4), qui est réalisée sous la forme d'un élément optique (19) et est intégrée au composant optique,
- dans lequel le substrat (1) présente sur sa première surface principale (2) au moins un élément d'étanchéité (35) qui est réalisé de manière à entourer la région de la première surface principale (2), sur lequel est appliqué l'élément optique (19) et qui assure l'étanchéité latérale avec l'élément optique (19), **caractérisé en ce que** l'élément d'étanchéité (35) présente une section transversale qui est réalisée de manière au moins partiellement triangulaire, trapézoïdale ou présente la forme d'une ellipse.
